(19) Europäisches Patentamt
European Patent Office
Office européen des brevets

(11) **EP 3 889 626 B1**

(12) **EUROPEAN PATENT SPECIFICATION**

(45) Date of publication and mention
of the grant of the patent:
**15.05.2024 Bulletin 2024/20**

(51) International Patent Classification (IPC):
**G01R 31/3842** (2019.01) **G01R 31/367** (2019.01)
**G01R 31/392** (2019.01)

(21) Application number: **21156794.6**

(22) Date of filing: **12.02.2021**

(52) Cooperative Patent Classification (CPC):
**G01R 31/3842; G01R 31/367; G01R 31/392;**
Y02E 60/10

(54) **BATTERY MANAGEMENT CONTROLLERS CAPABLE OF ESTIMATING STATE OF CHARGE**

BATTERIEVERWALTUNGS-CONTROLLER ZUR SCHÄTZUNG DES LADEZUSTANDS

CONTRÔLEURS DE GESTION DE BATTERIE CAPABLES D'ESTIMER L'ÉTAT DE CHARGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.02.2020 CN 202010124840**

(43) Date of publication of application:
**06.10.2021 Bulletin 2021/40**

(73) Proprietor: **O2Micro, Inc.**
**Santa Clara, CA 95054 (US)**

(72) Inventors:
• **Chou, Chih-Chung**
**Taipei City 105 (TW)**
• **Li, Guoxing**
**Sunnyvale, CA 94089 (US)**
• **Wang, Hua-Yi**
**Taipei City 105 (TW)**
• **Hsieh, Fu-Jen**
**Taipei City 105 (TW)**
• **Chen, Lian**
**Wuhan (CN)**

(74) Representative: **Lippert Stachow Patentanwälte
Rechtsanwälte
Partnerschaft mbB
Postfach 30 02 08
51412 Bergisch Gladbach (DE)**

(56) References cited:
**EP-A1- 2 778 697          EP-A1- 3 182 552
EP-A2- 2 793 038          WO-A1-2016/059869
CN-A- 106 772 101        JP-A- 2014 220 236
US-A1- 2005 046 389     US-A1- 2008 233 469
US-A1- 2010 289 454     US-A1- 2012 105 014
US-A1- 2012 223 670     US-A1- 2015 231 986
US-A1- 2016 041 229     US-A1- 2016 327 613
US-A1- 2018 120 385**

• **FARMANN ALEXANDER ET AL: "Critical review
of on-board capacity estimation techniques for
lithium-ion batteries in electric and hybrid electric
vehicles", JOURNAL OF POWER SOURCES,
ELSEVIER SA, CH, vol. 281, 22 January 2015
(2015-01-22), pages 114-130, XP029142623, ISSN:
0378-7753, DOI:
10.1016/J.JPOWSOUR.2015.01.129**

**Description**

REFERENCE TO RELATED APPLICATION

This application claims benefit under 35 U.S.C. § 119(a) to Application No. 202010124840.4, filed with the State Intellectual Property Office of the People's Republic of China on February 27, 2020.

BACKGROUND

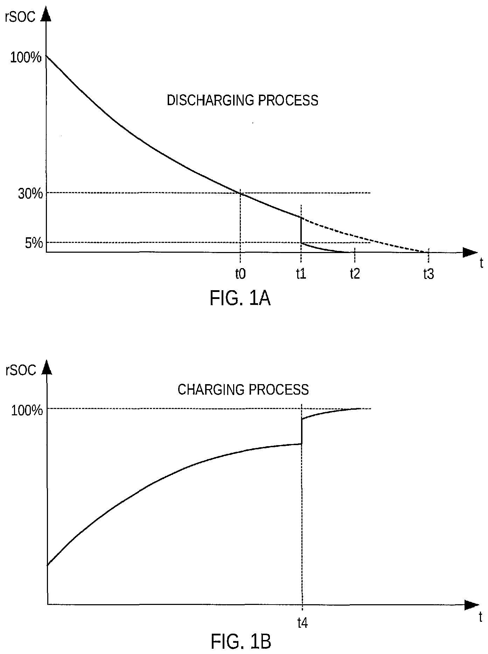

Portable devices are widely used in daily lives, and it is important to estimate available state of charge (or relative state of charge; rSoC) of the batteries in the portable devices. A conventional method for estimating an available state of charge of a battery includes two steps. The first step includes counting the amount of charges flowing through the battery using a coulomb counting method, obtaining an accumulated value of charges stored in the battery, and estimating the available state of charge of the battery based on the accumulated value. The second step includes searching a pre-stored lookup table for a remaining capacity that corresponds to a current battery voltage, a current battery current and a current battery temperature, and estimating the available state of charge based on the remaining capacity found in the lookup table. The first step is suited to a normal discharging state or a normal charging state of the battery. The second step is suited to the situations when the battery is close to an end-of-discharge state or a fully-charged state. However, due to non-ideality in practical situations, there are errors in the estimation of the available state of charge in the two steps respectively. These errors may result in the estimated value of the available state of charge changing abruptly when the battery transitions from the first step to the second step. Examples are illustrated in FIG. 1A and FIG. 1B.

FIG. 1A illustrates a plot for an estimated available state of charge of a battery in a discharging process, in a conventional battery management system. As shown in FIG. 1A, when the battery is in a normal discharging state (e.g., before time t1), the available state of charge rSoC is estimated based on the coulomb counting method. The available state of charge rSoC, as well as the battery voltage, decreases as the battery discharges. At time t1, the battery voltage decreases to a preset voltage level that is slightly greater than an end-of-discharge voltage of the battery, and therefore the battery enters a close-to-end-of-discharge state. In the close-to-end-of-discharge state, the available state of charge rSoC is estimated based on a pre-stored lookup table. Because the estimation method used before time t1 and that after time t1 are independent from each other, and each method has respective error, the available state of charge rSoC changes abruptly at time 11. The abrupt change may get larger and larger as the battery ages. The abrupt change can cause trouble to users, and sometime, it may cause serious damages to the users. For example, as shown in FIG. 1A, at time t0, a portable device (e.g., a mobile phone) shows that the battery has 30% remaining power, based on which a user judges that the battery can last at least until time t3. Thus, the user attends an important conference call on time as planned. During the important conference call, however, the mobile phone powers off unexpectedly.

Similarly, FIG. 1B illustrates a plot for an estimated available state of charge of a battery in a charging process, in a conventional battery management system. When the battery is in a normal charging state (e.g., before time t4), the available state of charge rSoC is estimated based on a coulomb counting method, and as the battery is charged, the available state of charge rSoC, as well as the battery voltage, increases. At time t4, the battery voltage increases to a preset voltage level that is approximately equal to a fully-charged voltage of the battery, and the battery enters a close-to-fully-charged state. In the close-to-fully-charged state, the available state of charge rSoC is estimated based on a lookup table. Because the estimation method used before time t4 and that after time t4 are independent from each other, and each method has respective error, the available state of charge rSoC changes abruptly at time t4. The abrupt change may cause trouble to users.

The technical paper "Critical review of on-board capacity estimation techniques for lithium-ion batteries in electric and hybrid electric vehicles", A, Farmann et al, Journal of Power Sources 281 (215) 114 - 130, refers to several methods and algorithms for on-board capacity estimation of lithium-ion batteries. A possible implementation of the use of an OCV (Open Circuit Voltage)-SOC (State-Of-Charge) relation for capacity estimation is shown. In the process, the OCV (t1) of the battery is measured at the beginning of a driving circle and the respective SOC (t1) is estimated by the predefined OCV-SOC relation. Then, OCV (t2) is measured referring to the battery voltage (OCV) during driving or after driving. When both SOCs are estimated, ΔSOC is calculated for the considered time span (t1... t2). Finally, the capacity of the battery is determined by dividing the transferred charge by the estimated ΔSOC. US 2008/0233469 A1 refers to a battery management system capable for determining the capacity of the battery on the basis of the just stated OCV-SOC relation. EP 3 182 552 A1 refers to lithium-sulfur battery management system comprising a first circuit having at least one reactive element, and the first circuit is configured to discharge and charge fixed amounts of charge from and to the battery via the at least one reactive element. The management system also comprises a second circuit for monitoring the discharging and charging, and the second circuit is configured to measure the discharge time and the charge time of the fixed amount of charge, and determine the state of charge based on those times. US 2015/0231986 A1 refers to a battery control system comprising a battery and at least one controller programed to generate model parameter estimates for the battery and, in response to a persistent excitation condition and an estimation convergence condition being satisfied, operate the battery according to a state of charge derived from the model parameter estimates.

## SUMMARY

In embodiments, a battery management controller includes analog-to-digital conversion circuitry, a memory, and a processor. The analog-to-digital conversion converts analog signals, indicative of a current battery voltage, a current battery current, and a current battery temperature of a battery, to digital signals. The memory stores a remaining-capacity lookup table that includes multiple groups of data. Each group of the groups of data includes a voltage, a current, a temperature, and a parameter associated with a remaining capacity that corresponds to the voltage, the current and the temperature. The processor receives a signal, indicative of a battery current, from the analog-to-digital conversion circuitry thereby counting the amount of charges flowing through the battery. The processor also searches the remaining-capacity lookup table for a current parameter value corresponding to the current battery voltage, the current battery current, and the current battery temperature according the digital signals, searches the remaining-capacity lookup table for an end-of-discharge parameter value corresponding to an end-of-discharge voltage indicative for entering an end-of-discharge state to protect the battery from over-discharging" the current battery current, and an end-of-discharge temperature, and estimates a current full available charge capacity of the battery according to a difference between the current parameter value and the end-of-discharge parameter value. The processor further estimates a current available state of charge of the battery according to the current full available charge capacity and the amount of charges flowing through the battery.

In a further embodiment, a battery management system comprises a sensing circuitry configured to generate analog signals indicative of a current battery voltage, a current battery current, and a current battery temperature of a battery; and a battery management controller, coupled to said sensing circuitry, and configured to convert said analog signals to digital signals, wherein said battery management controller comprises: a memory configured to store a remaining-capacity lookup table that comprises a plurality of groups of data, wherein each group of said groups of data includes a voltage, a current, a temperature, and a parameter associated with a remaining capacity that corresponds to said voltage, said current and said temperature; and a processor coupled to said memory, wherein said processor is configured to search said remaining-capacity lookup table for a current parameter value corresponding to said current battery voltage, said current battery current, and said current battery temperature according said digital signals, search said remaining-capacity lookup table for an end-of-discharge parameter value corresponding to an end-of-discharge voltage, said current battery current, and an end-of-discharge temperature, and estimate a current full available charge capacity of said battery according to a difference between said current parameter value and said end-of-discharge parameter value, and wherein said processor is also configured to count the amount of charges flowing through said battery according to a battery current of said battery, and estimate a current available state of charge of said battery according to said current full available charge capacity and said amount of charges flowing through said battery. Further, in some embodiments of said battery management system, said parameter comprises a state of charge, said current parameter value comprises a current absolute state of charge of said battery, and said end-of-discharge parameter value comprises an end-of-discharge (EOD) state of charge of said battery, and wherein said processor is configured to estimate said current full available charge capacity according to the following equation: $DFC=FACC\times(aSOC_N-aSOC_{EOD})/rSOC_{N-1}$, where DFC represents said current full available charge capacity, FACC represents a current full absolute charge capacity of said battery, $aSOC_N$ represents said current absolute state of charge, and $aSOC_{EOD}$ represents said end-of-discharge state of charge, and $rSOC_{N-1}$ represents a previously estimated available state of charge of said battery. Furthermore, said processor may be configured to estimate said current available state of charge according to the following equation: $rSOC_N=[(DFC\times rSOC_{N-1})+Q(t)]/DFC$, where $rSOC_N$ represents said current available state of charge, and Q(t) presents said amount of charges flowing through said battery.

## BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:

FIG. 1A illustrates a plot for an estimated available state of charge of a battery in a discharging process, in a conventional battery management system.

FIG. 1B illustrates a plot for an estimated available state of charge of a battery in a charging process, in a conventional battery management system.

FIG. 2A illustrates a block diagram of an example of a battery management system that is capable of estimating a state of charge of a battery, in an embodiment of the present invention.

FIG. 2B illustrates a block diagram of an example of a battery management system that is capable of estimating a state of charge of a battery, in an embodiment of the present invention.

FIG. 3 illustrates an example of a plot for a voltage of a battery under various states, in an embodiment of the present invention.

FIG. 4 illustrates an example of a plot for a voltage of a battery under various states, in an embodiment of the present invention.

FIG. 5 illustrates an example of a method for updating a full-absolute-charge capacity of a battery, in an embodiment of the present invention.

FIG. 6A illustrates examples of plots for temperature changes in different situations based on examples of experimental data, in embodiments of the present invention.

FIG. 6B illustrates examples of plots for temperature changes in different situations based on examples of experimental data, in embodiments of the present invention.

FIG. 6C illustrates examples of plots for temperature changes in different situations based on examples of experimental data, in embodiments of the present invention.

FIG. 6D illustrates examples of plots for temperature changes in different situations based on examples of experimental data, in embodiments of the present invention.

FIG. 7 illustrates examples of plots for temperature changes in different situations based on examples of experimental data, in embodiments of the present invention.

FIG. 8 illustrates a block diagram of an example of a battery management system, in an embodiment of the present invention.

FIG. 9A illustrates a method of estimating an end-of-discharge temperature of a battery, in an embodiment of the present invention.

FIG. 9B illustrates a method of estimating an end-of-discharge temperature of a battery, in an embodiment of the present invention.

FIG. 10 illustrates an example of a method for estimating an available state of charge of a battery, in an embodiment of the present invention.

DETAILED DESCRIPTION

Reference will now be made in detail to the embodiments of the present invention. While the invention will be described in conjunction with these embodiments, it will be understood that they are not intended to limit the invention to these embodiments. On the contrary, the invention is intended to cover alternatives and modifications which may be included within the scope of the invention as defined by the appended claims

Furthermore, in the following detailed description of the present invention, numerous specific details are set forth in order to provide a thorough understanding of the present invention. However, it will be recognized by one of ordinary skill in the art that the present invention may be practiced without these specific details. In other instances, well known methods, procedures, components, and circuits have not been described in detail as not to unnecessarily obscure aspects of the present invention.

Some portions of the detailed descriptions that follow are presented in terms of procedures, logic blocks, processing, and other symbolic representations of operations on data bits within a computer memory. These descriptions and representations are the means used by those skilled in the data processing arts to most effectively convey the substance of their work to others skilled in the art. In the present application, a procedure, logic block, process, or the like, is conceived to be a self-consistent sequence of steps or instructions leading to a desired result. The steps are those utilizing physical manipulations of physical quantities. Usually, although not necessarily, these quantities take the form of electrical or magnetic signals capable of being stored, transferred, combined, compared, and otherwise manipulated in a computer system. It has proven convenient at times, principally for reasons of common usage, to refer to these signals as transactions, bits, values, elements, symbols, characters, samples, pixels, or the like.

It should be borne in mind, however, that all of these and similar terms are to be associated with the appropriate physical quantities and are merely convenient labels applied to these quantities. Unless specifically stated otherwise as apparent from the following discussions, it is appreciated that throughout the present disclosure, discussions utilizing terms such as "accessing," "searching," "estimating," "counting," "updating," "obtaining," or the like, refer to actions and processes of a computer system or similar electronic computing device, controller, or processor. The computer system or similar electronic computing device manipulates and transforms data represented as physical (electronic) quantities within the computer system memories, registers or other such information storage, transmission or display devices.

Portions of the detailed description that follows are presented and discussed in terms of methods. Although steps and sequencing thereof are disclosed in figures herein describing the operations of those methods, such steps and sequencing are examples only. Embodiments are well suited to performing various other steps or variations of the steps recited in the flowcharts of the figures herein, and in a sequence other than that depicted and described herein.

Embodiments described herein may be discussed in the general context of computer-executable instructions residing on some form of computer-readable storage medium, such as program modules, executed by one or more computers, controllers, or other devices. By way of example, and not limitation, computer-readable storage media may comprise nontransitory computer storage media and communication media. Generally, program modules include routines, programs, objects, components, data structures, etc., that perform particular tasks or implement particular abstract data types. The functionality of the program modules may be combined or distributed as desired in various embodiments.

Computer storage media includes volatile and nonvolatile, removable and nonremovable media implemented in any method or technology for storage of information such as computer-readable instructions, data structures, program modules or other data. Computer storage media includes, but is not limited to, random access memory (RAM), read only memory (ROM), electrically erasable programmable ROM (EEPROM), flash memory or other memory technology, compact disk ROM (CD-ROM), digital versatile disks (DVDs) or other optical storage, magnetic cassettes, magnetic tape, magnetic disk storage or other magnetic storage devices, or any other medium that can be used to store the desired information and that can accessed to retrieve that information.

Communication media can embody computer-executable instructions, data structures, and program modules, and includes any information delivery media. By way of example, and not limitation, communication media includes wired media such as a wired network or direct-wired connection, and wireless media such as acoustic, radio frequency (RF), infrared and other wireless media. Combinations of any of the above can also be included within the scope of computer-readable media.

Embodiments of the present invention provide estimation methods for estimating an available state of charge (or a relative state of charge; rSoC) of a battery. The estimation method combines coulomb counting and a remaining-capacity lookup table in a specific way to estimate the available state of charge of the battery, thereby eliminating the abrupt change in the estimated value of the available state of charge that exists in the prior art. Thus, users can make more accurate judgments on how to operate portable devices based on the estimated available state of charge. Additionally, embodiments of the present invention provide improved methods for obtaining a more accurate available state of charge of the battery by estimating aging factors of the battery, and updating a full absolute charge capacity of the battery according to the aging factors. Moreover, embodiments of the present invention provide improved methods for obtaining a more accurate available state of charge of the battery by estimating an end-of-discharge temperature, and updating a dynamic full capacity of the battery based on the end-of-discharge temperature.

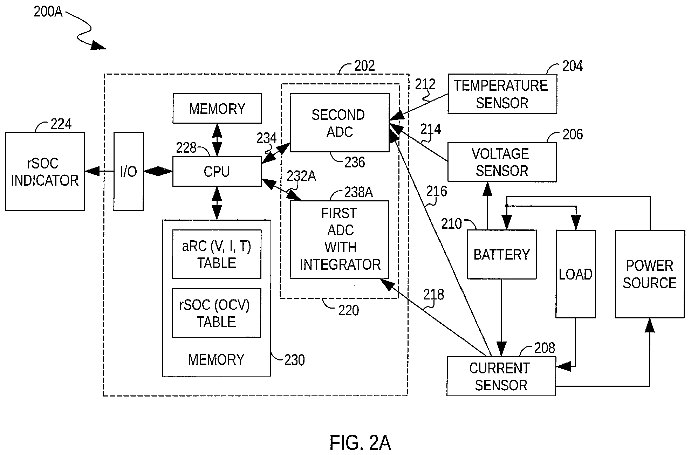

FIG. 2A illustrates a block diagram of an example of a battery management system 200A that is capable of estimating a state of charge of a battery 210, in an embodiment of the present invention. The battery management system 200A can monitor and control statuses of the battery 210. In an embodiment, the battery management system 200A monitors a temperature, a voltage, and a current of the battery 210 through sensing circuitry, e.g., including circuits 204, 206 and 208, and estimates an available state of charge of the battery 210 based on the temperature, voltage, and current. The battery management system 200A also controls an rSoC indicator 224, e.g., a display screen, to display the estimated value of the available state of charge in a percentage format. In an embodiment, the battery 210 includes one or more rechargeable battery cells (e.g., lithium ion battery cells).

More specifically, as shown in FIG. 2A, the battery management system 200A can include a temperature sensing circuit 204, a voltage sensing circuit 206, a current sensing circuit 208, and a battery management controller 202. The temperature sensing circuit 204 can include, but is not limited to, a thermistor that generates a first signal 212 indicative of a battery temperature $T_{BAT}$ of the battery 210. The voltage sensing circuit 206 can include, but is not limited to, a voltage divider, coupled to a positive terminal of the battery 210, and that generates a second signal 214 indicative of a battery voltage $V_{BAT}$ of the battery 210. The current sensing circuit 208 can include, but is not limited to, a sensing resistor, coupled in series to the battery 210. The current sensing circuit 208 can generate a third signal 216 and a fourth signal 218 indicative of a battery current $I_{BAT}$ of the battery 210. In an embodiment, the third signal 216 and the fourth signal 218 are generated from the same current sensing component, and therefore they are the same signal. In another embodiment, the third signal 216 and the fourth signal 218 can be generated by two separate current sensing components, and therefore they can be two different signals. The battery management controller 202 can receive signals 212, 214, 216 and 218 from the sensing circuits (e.g., including the sensing circuits 204, 206, and 208), and estimate the available state of charge of the battery 210 based on these signals. In an embodiment, the battery management controller 202 includes analog-to-digital conversion circuitry 220, a memory 230, and a processor 228.

In an embodiment, the analog-to-digital conversion circuitry 220 includes a first analog-to-digital converter 238A (hereinafter, ADC 238A) and a second analog-to-digital converter 236 (hereinafter ADC 236). The first ADC 238A can include a high-accuracy converter capable of obtaining relatively accurate information for the battery current. The first ADC 238A can convert an analog signal 218 from the current sensing circuit 208, indicative of a current battery current $I_N$ of the battery 210, to a computer-readable digital signal 232A. The second ADC 236 can include a high-speed converter capable of obtaining information for the battery temperature, battery voltage, and battery current relatively fast. In an embodiment, a speed of conversion of the second ADC 236 is higher than a speed of conversion of the first ADC 238A. The second ADC 236 can convert analog signals 214, 216 and 222, indicative of a current battery voltage $V_N$ (or a real-time value of the battery voltage $V_{BAT}$), a current battery current $I_N$ (or a real-time value of the battery current $I_{BAT}$), and a current battery temperature $T_N$ (or a real-time value of the battery temperature $T_{BAT}$), to computer-readable digital signals 234. The processor 228 can estimate a state of charge SoC of the battery 210 based on the digital signals from the ADCs 236 and 238A, and based on parameters of the battery 210 such as a full charge capacity FCC and a remaining capacity RC.

In an embodiment, the full charge capacity FCC includes a full absolute charge capacity FACC and a full relative charge capacity FRCC. The full absolute charge capacity FACC refers to the total amount of charges stored in a battery when the battery is fully charged. Additionally, the full absolute charge capacity FACC includes a predetermined full absolute charge capacity pFACC and an actual full absolute charge capacity. The predetermined full absolute charge capacity pF ACC refers to a designed value of the full absolute charge capacity FACC of a battery when the battery is brand new. The actual full absolute charge capacity FACC can decrease gradually as the battery ages. The full relative charge capacity FRCC can also be referred to as full available charge capacity or dynamic full capacity DFC. The full available charge capacity or the dynamic full capacity DFC refers to the amount of charges that can be discharged from a battery when the battery is fully charged. More specifically, in an embodiment, when a battery powers a load, the battery's voltage $V_{BAT}$ decreases as the battery discharges. When the battery voltage $V_{BAT}$ decreases to an end-of-discharge voltage $V_{EOD}$ ($V_{EOD} > 0$), the battery enters an end-of-discharge state, and the battery management system stops discharging the battery to protect the battery from over-discharging. The full available charge capacity DFC refers to the amount of charges that are discharged from the battery from the time when the battery is fully charged to the time when the battery enters the end-of-discharge state.

In an embodiment, the remaining capacity RC includes an absolute remaining capacity aRC and a relative remaining capacity rRC. The absolute remaining capacity aRC refers to the total amount of charges remained in a battery. The relative remaining capacity rRC can also be referred to as available remaining capacity. The relative remaining capacity rRC (or available remaining capacity rRC) refers to the amount of remained charges that can be discharged from a battery until the battery enters the abovementioned end-of-discharge state. The state of charge SoC includes an absolute state of charge aSoC and a relative state of charge rSoC. The absolute state of charge aSoC refers to a ratio of the absolute remaining capacity aRC to the abovementioned predetermined full absolute charge capacity pF ACC, e.g., aSoC=aRC/pFACC. The relative state of charge rSoC can also be referred to as available state of charge. The relative state of charge rSoC (or available state of charge rSoC) refers to a ratio of the available remaining capacity rRC to the abovementioned full available charge capacity DFC, e.g., rSoC=rRC/DFC.

In an embodiment, the memory 230 pre-stores a remaining-capacity lookup table aRC (V, I, T) and a state-of-charge lookup table rSoC (OCV). The remaining-capacity lookup table aRC (V, I, T) includes multiple groups of data. Each group includes data for a voltage V, a current I, a temperature T, and a parameter associated with a remaining capacity aRC that corresponds to the voltage V, current I and temperature T. The parameter can include an absolute remaining capacity aRC and/or an absolute state of charge aSoC (e.g., aSoC=aRC/pFACC). More specifically, an absolute remaining capacity aRC, and similarly an absolute state of charge aSoC, of a battery have corresponding relationship with the battery's voltage V, current I, and temperature T. In an embodiment, the corresponding relationship can be given by a specific function aRC=f(V, I, T) or aSoC=f(V, I, T). Thus, the absolute remaining capacity aRC can be obtained through the function aRC=f(V, I, T). Similarly, the absolute state of charge aSoC can be obtained through the function aSoC=f(V, I, T). In an embodiment, the specific function aRC=f(V, I, T) or aSoC=f(V, I, T) can also be represented by the lookup table aRC (V, I, T), and the abovementioned parameter in the each group of data includes an absolute remaining capacity aRC or an absolute state of charge aSoC. Thus, the absolute remaining capacity aRC or the absolute state of charge aSoC can be obtained by searching the lookup table aRC (V, I, T).

In an embodiment, the state-of-charge lookup table rSoC (OCV) can also be referred to as state-of-charge vs open-circuit-voltage lookup table OCV-SOC, or open-circuit-voltage vs state-of-charge lookup table SOC-OCV. The state-of-charge lookup table rSoC (OCV) includes multiple data groups, and each data group includes a voltage value OCV, e.g., an open-circuit voltage, and a state of charge rSoC corresponding to the voltage value OCV. More specifically, an available state of charge rSoC of a battery has a corresponding relationship with the battery's open-circuit voltage OCV, and the corresponding relationship can be indicated by the data stored in the lookup table rSoC (OCV). The available state of charge rSoC can be obtained by searching the lookup table rSoC (OCV).

The processor 228 can include a central processing unit, a microprocessor, a microcontroller, or a similar device that is capable of processing data and performing calculation. In an embodiment, the processor 228 receives a signal 232A, indicative of a current of the battery 210, from the first ADC 238A, thereby counting the amount of charges $Q(t)$ flowing through the battery 210. The processor 228 also receives digital signals 234 from the second ADC 236, and searches the remaining-capacity lookup table aRC (V, I, T) for a current absolute remaining capacity $aRC_N$ corresponding to a current battery voltage $V_N$, a current battery current $I_N$, and a current battery temperature $T_N$ according the digital signals 234, e.g., $aRC_N = f(V_N, I_N, T_N)$. The processor 228 also searches the lookup table aRC (V, I, T) for an end-of-discharge remaining capacity $aRC_{EOD}$ (hereinafter, EOD reaming capacity $aRC_{EOD}$) corresponding to an end-of-discharge voltage $V_{EOD}$, the current battery current $I_N$, and the current battery temperature $T_N$ (or an end-of-discharge temperature $T_{EOD}$). Additionally, the processor 228 estimates a current full available charge capacity DFC of the battery 210 according to a difference between the current absolute remaining capacity $aRC_N$ and the EOD remaining capacity $aRC_{EOD}$, and estimates a current available state of charge $rSoC_N$ of the battery 210 according to the current full available charge capacity DFC and the abovementioned amount of charges $Q(t)$.

More specifically, the amount of charges $Q(t)$ flowing through the battery 210 can be obtained by coulomb counting. The amount of charges $Q(t)$ can be given by equation (1) as follows:

$$Q(t) = \int_{t0}^{tn} I_N dt. \qquad (1)$$

In equation (1), $I_N$ represents a real-time value of the battery current.

In the example of FIG. 2A, the first ADC 238A includes an analog-to-digital converter with integral function. For example, the first ADC 238A can include an integration circuit that integrates the analog signal 218 to generate a ramp signal. The first ADC 238A can also include a comparison circuit that compares the ramp signal with a preset reference. When the ramp signal increases to the preset reference, the comparison circuit generates a result signal 232A (e.g., a logic-high signal or digital 1, or a logic-low signal or digital 0), and resets the ramp signal to generate a new ramp signal. As a result, the comparison circuit can output a set of result signals 232A. The frequency of the result signals 232A can increase if the battery current increases, and decrease if the battery current decreases. The processor 228 can count the result signals 232A, and the number of the result signals 232A can indicate the amount of charges $Q(t)$ flowing through the battery 210. Accordingly, the processor 228 can receive a signal 232A, indicative of an integral value of the battery current $I_N$, from the first ADC 238A thereby obtaining the amount of charges $Q(t)$ flowing through the battery 210.

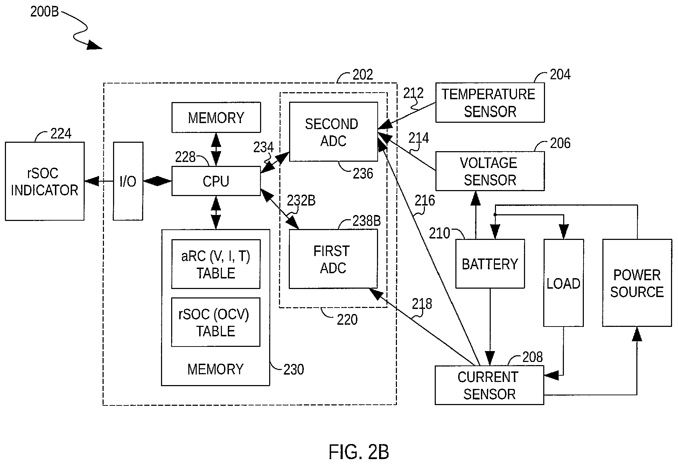

The invention is not limited to the example of FIG. 2A. In another example, as shown in FIG. 2B, the first ADC 238B does not have integration function, and can convert the analog signal 218 to a set of binary codes 232B, and the value represented by the binary codes 232B can be proportional to the battery current $I_N$. The processor 228 can accumulate the values of multiple sets of binary codes 232B generated by the first ADC 23 8B, thereby calculating the amount of charges $Q(t)$ flowing through the battery 210. The abovementioned examples of methods of counting the amount of charges $Q(t)$ flowing through the battery 210 are for explanation purpose, and are not intended to limit the invention. In other embodiments, the amount of charges $Q(t)$ flowing through the battery 210 can be obtained by other methods.

In an embodiment, the processor 228 receives digital signals 234, converted from the analog signals 212, 214, and 216 by the second ADC 236, thereby obtaining the values of a current battery voltage $V_N$, a current battery current $I_N$, and a current battery temperature $T_N$. The processor 228 also searches the lookup table aRC (V, I, T) for a current absolute remaining capacity $aRC_N$ that corresponds to the current battery voltage $V_N$, the current battery current $I_N$ and the current battery temperature $T_N$. The current absolute remaining capacity $aRC_N$ can be represented by:

$$aRC_N = f(V_N, I_N, T_N). \qquad (2a)$$

More specifically, in an embodiment, the processor 228 obtains the current absolute remaining capacity $aRC_N$ by searching the multiple groups of data in the lookup table aRC (V, I, T) for a corresponding group of data. The corresponding group of data includes a voltage V, a current I and a temperature T that match the current battery voltage $V_N$, the current battery current $I_N$ and the current battery temperature $T_N$, respectively. In an embodiment, if a difference between a first value of a parameter and a second value of the parameter is less than a preset reference, then the first value is considered to match the second value. For example, if a difference between a voltage V in the lookup table $aRC(V, I, T)$ and the current battery voltage $V_N$ is less than a preset reference, then that voltage V is considered to match the current battery voltage $V_N$. If the abovementioned corresponding group of data is found, then the processor 228 obtains (e.g., reads) the remaining capacity aRC in the corresponding group of data. The remaining capacity aRC in the corresponding group of data can be considered as the current absolute remaining capacity $aRC_N$.

In another embodiment, if the corresponding group of data is not found, then the processor 228 can perform a mathematical method, such as linear interpolation, to estimate the current absolute remaining capacity $aRC_N$. More specifically, in mathematics, linear interpolation is a method of curve fitting using linear polynomials to construct new data points within the range of a discrete set of known data points. In an embodiment, the lookup table $aRC(V, I, T)$ may not include a voltage, a current, and/or a temperate that match the current battery voltage $V_N$, the current battery current $I_N$, and/or the current battery temperature $T_N$. In one such embodiment, the processor 228 can perform linear interpolation to construct a new set of data that match the current battery voltage $V_N$, the current battery current $I_N$, and the current battery temperature $T_N$, according to the data in the lookup table $aRC(V, I, T)$. The new set of data also includes a remaining capacity aRC, which can be considered as the current absolute remaining capacity $aRC_N$.

Additionally, as mentioned above, the battery 210 has an end-of-discharge voltage $V_{EOD}$. During a discharging process, when the battery voltage $V_N$ decreases to the end-of-discharge voltage $V_{EOD}$, the battery 210 enters an end-of-discharge state and stops discharging. In an embodiment, the temperature of the battery 210 can be relatively stable because, e.g., the discharge current of the battery 210 is relatively small. In one such embodiment, the temperature of the battery 210 at the time when the battery 210 enters the end-of-discharge state can be approximately equal to the current battery temperature $T_N$. The processor 228 can assume that the end-of-discharge temperature $T_{EOD}$ of the battery 210 will be equal to the current battery temperature $T_N$. Thus, the processor 228 can obtain an estimated value of an EOD remaining capacity $aRC_{EOD}$ of the battery 210 by searching the lookup table $aRC(V, I, T)$ for a remaining capacity that corresponds to the end-of-discharge voltage $V_{EOD}$, the current battery current $I_N$, and the current battery temperature $T_N$.

$$aRC_{EOD} = f(V_{EOD}, I_N, T_N) \qquad (2b)$$

More specifically, in an embodiment, the processor 228 searches the multiple groups of data in the lookup table $aRC(V, I, T)$ for a corresponding group of data. The corresponding group of data includes a voltage V, a current I and a temperature T that match the end-of-discharge voltage $V_{EOD}$, the current battery current $I_N$, and the current battery temperature $T_N$. If the corresponding group of data is found, then the remaining capacity aRC in the corresponding group of data can be considered as the EOD remaining capacity $aRC_{EOD}$. If the corresponding group of data is not found, then the processor 228 can perform linear interpolation to estimate the EOD remaining capacity $aRC_{EOD}$ based on the data in the lookup table $aRC(V, I, T)$.

As a result, the processor 228 can estimate a current full available charge capacity DFC of the battery 210 according to the difference between the current absolute remaining capacity $aRC_N$ and the EOD remaining capacity $aRC_{EOD}$. By way of example, the processor 228 can estimate the current full available charge capacity DFC of the battery 210 according equation (2c) as follows:

$$DFC = FACC \times \frac{(aRC_N - aRC_{EOD})}{(pFACC \times rSOC_{N-1})} . \qquad (2c)$$

In equation (2c), FACC represents a current full absolute charge capacity (e.g., indicative of an actual full absolute charge capacity) of the battery 210, pFACC represents a predetermined full absolute charge capacity of the battery 210, and $rSoC_{N-1}$ represents a previously estimated available state of charge of the battery 210.

In addition, the processor 228 estimates a current available state of charge $rSoC_N$ of the battery 210 according to the current full available charge capacity DFC and the abovementioned mount of charges $Q(t)$ flowing through the battery 210. By way of example, the processor 228 can estimate the current available state of charge $rSoC_N$ of the battery 210 according to the following equation:

$$rSoC_N = \frac{(DFC \times rSoC_{N-1}) + Q(t)}{DFC} . \qquad (3)$$

Accordingly, an embodiment of the present invention provides a method of combing coulomb counting and a remaining-capacity lookup table aRC (V, I, T) in a specific manner to estimate an available state of charge $rSoC_N$ of a battery. More specifically, in an embodiment, the processor 228 obtains the values of the current absolute remaining capacity $aRC_N$ and the EOD remaining capacity $aRC_{EOD}$ using the remaining-capacity lookup table aRC (V, I, T), thereby calculating the current full available charge capacity DFC according to equation (2c). The processor 228 also obtains the amount of charges Q(t) flowing through the battery 210 by coulomb counting, and estimates the available state of charge $rSoC_N$ of the battery 210 by substituting the amount of charges Q(t) and the current full available charge capacity DFC into equation (3). Thus, the abrupt change in the estimated value of the available state of charge rSoC in the prior art can be eliminated in an embodiment of the present invention. Users can make more accurate judgment on how to operate the portable devices based on the estimated available state of charge rSoC.

In another embodiment, the abovementioned equation (2c) can be replaced by the following equation (4a). The processor 228 can estimate the current full available charge capacity DFC of the battery 210 according to the following equation:

$$DFC = FACC \times \frac{(aSoC_N - aSoC_{EOD})}{rSoC_{N-1}} . \qquad (4a)$$

In equation (4a), $aSoC_N$ represents a current absolute state of charge, e.g., a ratio of a current absolute remaining capacity $aRC_N$ to the predetermined full absolute charge capacity pF ACC, of the battery 210, $aSoC_{EOD}$ represents an end-of-discharge state of charge (hereinafter, EOD state of charge), e.g., a ratio of an EOD remaining capacity $aRC_{EOD}$ to the predetermined full absolute charge capacity pFACC, of the battery 210.

In an embodiment, the current absolute state of charge $aSoC_N$ can be obtained by dividing the current absolute remaining capacity $aRC_N$ that, as mentioned above, is obtained from the lookup table aRC (V, I, T) by the predetermined full absolute charge capacity pF ACC, e.g., $aSoC_N = aSoC_N/pFACC$. Similarly, the EOD state of charge $aSoC_{EOD}$ can be obtained by dividing the EOD remaining capacity $aRC_{EOD}$ that, as mentioned above, is obtained from the lookup table aRC (V, I, T) by the predetermined full absolute charge capacity pF ACC, e.g., $aSoC_{EOD} = aSoC_{EOD}/pFACC$. In equation (4a), the difference between the current absolute state of charge $aSoC_N$ and the EOD state of charge $aSoC_{EOD}$ indicates the difference between the current absolute remaining capacity $aRC_N$ and the EOD remaining capacity $aRC_{EOD}$.

In another embodiment, as mentioned above, the lookup table aRC (V, I, T) can include data for absolute state of charge $aSoC_N$. Thus, the processor 228 can obtain the current absolute state of charge $aSoC_N$ by searching the lookup table aRC (V, I, T) for a state of charge that corresponds to the current battery voltage $V_N$, the current battery current $I_N$, and the current battery temperature $T_N$. The current absolute state of charge $aSoC_N$ can be represented by:

$$aSOC_N = f(V_N, I_N, T_N). \qquad (4b)$$

Similarly, the processor 228 can obtain the EOD state of charge $aSoC_{EOD}$ by searching the lookup table aRC (V, I, T) for a state of charge that corresponds to the end-of-discharge voltage $V_{EOD}$, the current battery current $I_N$, and the current battery temperature $T_N$. The EOD state of charge $aSoC_{EOD}$ can be represented by:

$$aSOC_{EOD} = f(V_{EOD}, I_N, T_N). \qquad (4c)$$

Additionally, the processor 228 can estimate the current full available charge capacity DFC of the battery 210 based on a difference between the current absolute state of charge $aSoC_N$ and the EOD state of charge $aSoC_{EOD}$, e.g. by using equation (4a).

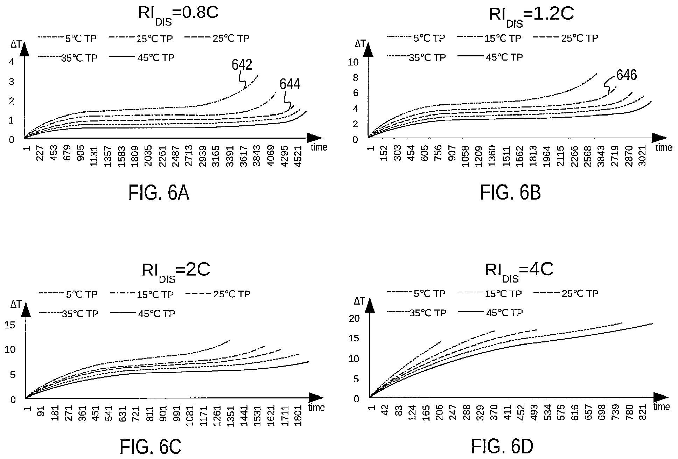

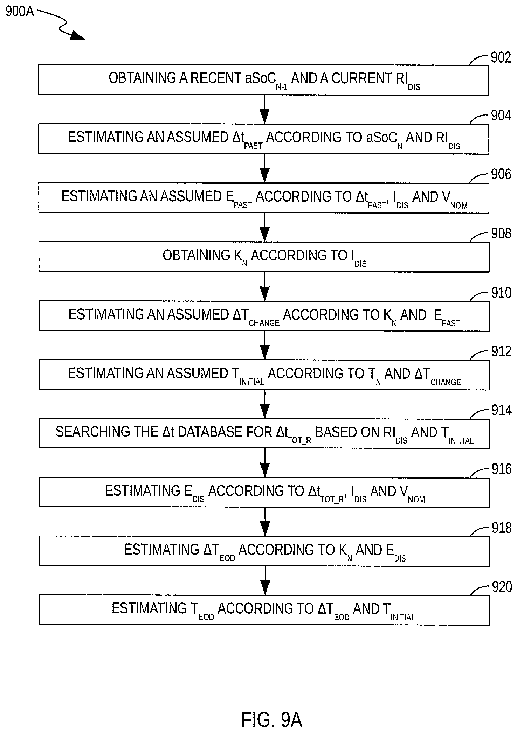

In an embodiment, as mentioned above, the temperature of the battery 210 can be relatively stable because, e.g., the discharge current of the battery is relatively small, and the battery temperature does not change a lot when the battery 210 enters the end-of-discharge state. Thus, the processor 228 can estimate the EOD remaining capacity $aRC_{EOD}$ (or the EOD state of charge $aSoC_{EOD}$) of the battery 210 by searching the lookup table aRC (V, I, T) for a remaining capacity (or a state of charge) corresponding to a current battery temperature. However, the invention is not so limited. In another embodiment, a discharge current of the battery 210 can be relatively large, which results in plenty of heat in the battery 210. In one such embodiment, the processor 228 can estimate an end-of-discharge temperature $T_{EOD}$ of the battery 210. An example of a method of estimating the end-of-discharge temperature $T_{EOD}$ is described in FIG. 9A, in combination with FIG. 6A, FIG. 6B, FIG. 6C, FIG. 6D, FIG. 7 and FIG. 8. The processor 228 also estimates the EOD remaining capacity $aRC_{EOD}$ (or the EOD state of charge $aSoC_{EOD}$) of the battery 210 by searching the lookup table aRC (V, I, T) for a remaining capacity (or a state of charge) that corresponds to the end-of-discharge voltage $V_{EOD}$, the current battery current $I_N$, and the end-of-discharge temperature $T_{EOD}$, e.g., $aRC_{EOD} = f(V_{EOD}, I_N, T_{EOD})$ or $aSoC_{EOD}$

= f($V_{EOD}$, $I_N$, $T_{EOD}$). As a result, a more accurate EOD remaining capacity $aRC_{EOD}$ (or EOD state of charge $aSoC_{EOD}$) of the battery 210 can be obtained, and the processor 228 can use equation (3) and equation (2c) or (4a) to obtain a more accurate available state of charge $rSoC_N$ of the battery 210.

Moreover, in an embodiment, the processor 228 calculates aging factors of the battery 210 and updates a current full absolute charge capacity FACC (e.g., indicative of an actual full absolute charge capacity) of the battery 210 based on the aging factors. The processor 228 substitutes the updated current full absolute charge capacity FACC into equation (2c) or equation (4a) thereby updating a current full available charge capacity DFC of the battery 210. The processor 228 further substitutes the updated current full available charge capacity DFC into equation (3) to obtain a more accurate available state of charge rSoC. The aging factors include a charging aging factor AFC and a discharging aging factor AFD.

More specifically, in an embodiment, ideally, when a battery is a charging process, a ratio of the amount of charges $Q(t)_{CHG}$ flowing to the battery to the amount of change $\Delta rSoC$ in the available state of charge of the battery is a constant, e.g., does not change. However, in a practical situation, the ratio $Q(t)_{CHG}/\Delta rSoC$ can change, e.g., decrease, as the battery ages. The ratio $Q(t)_{CHG}/\Delta rSoC$ can be referred to as a charging aging factor AFC, e.g., AFC=$Q(t)_{CHG}/\Delta rSoC$. Additionally, in an embodiment, when a battery starts discharging, the battery's voltage $V_{BAT}$ can drop from an initial open-circuit voltage OCV to a lower battery voltage by an amount $\Delta V$. Ideally, a ratio of the voltage drop $\Delta V$ to the battery's discharge current $I_{DIS}$ is a constant. However, in a practical situation, the ratio $\Delta V/I_{DIS}$ can change, e.g., decrease, as the battery ages. The ratio $\Delta V/I_{DIS}$ can be referred to as a discharging aging factor AFD (e.g., AFD=$\Delta V/I_{DIS}$).

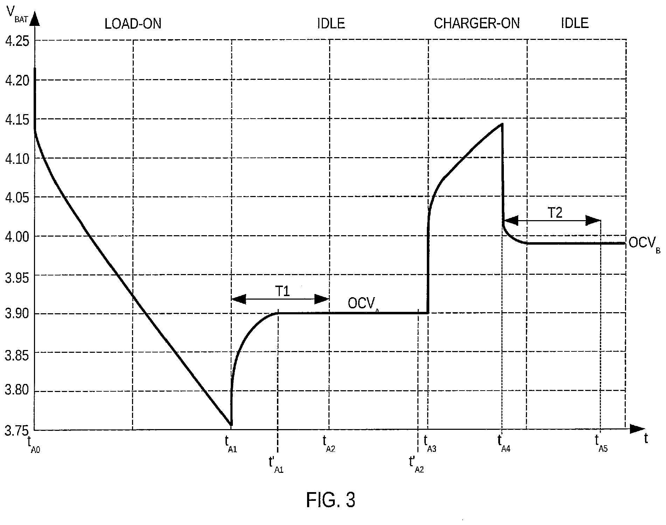

FIG. 3 illustrates an example of a plot for a voltage $V_{BAT}$ of the battery 210 in various states, in an embodiment of the present invention. FIG. 3 is described in combination with FIG. 2A and FIG. 2B to explain how to calculate a charging aging factor AFC of the battery 210. As shown in FIG. 3, the battery 210 transitions from a load-on state (or a discharging state) to an idle state at time $t_{A1}$, transitions from the idle state to a charging state at time $t_{A3}$, and transitions from the charging state to another idle state at time $t_{A4}$. The idle state from time $t_{A1}$ to time $t_{A3}$ can be referred to as first idle state. The idle state after time $t_{A4}$ can be referred to as second idle state. In an embodiment, when the battery 210 is neither charged nor discharged (or when the battery 210 has a discharge current, and the discharge current is so small that it can be ignored), the battery 210 is in an idle state. By way of examples, if a portable device is powered off (or the portable device is not in use under an ultra power saving mode, an airplane mode, or the like), and the portable device is not being charged, then the battery in the portable device can be considered to be in an idle state.

In an embodiment, when the battery 210 transitions from a load-on state to an idle state, the battery voltage $V_{BAT}$ can increase until it reaches a stabilized open-circuit voltage. When the battery 210 transitions from a charging state to an idle state, the battery voltage $V_{BAT}$ can decrease until it reaches a stabilized open-circuit voltage. As shown in FIG. 3A, after entering the first idle state, the open-circuit voltage of the battery 210 gradually stabilizes. When the open-circuit voltage has stabilized (e.g., from time $t'_{A1}$ to time $t_{A3}$), the processor 228 obtains, from the second ADC 236, a first open-circuit voltage $OCV_A$ of the battery 210 in the first idle state. In an embodiment, as used herein, an "open-circuit voltage has stabilized" means that a rate of change in the open-circuit voltage is relatively small, e.g., less than a preset reference, and the rate of change can be ignored. For example, if the processor 228 detects that the battery 210 enters the first idle state, the processor 228 can start a timer. When a predetermined time interval T1 expires, e.g., at time $t_{A2}$, the open-circuit voltage is considered to have stabilized, and the processor 228 obtains a first open-circuit voltage $OCV_A$ from the second ADC 236. For another example, the battery management controller 202 can include a register or a memory that records the battery voltage $V_{BAT}$ of the battery 210. If the processor 228 detects that the battery 210 transitions from the first idle state to a charging state, then the processor 228 can read, from the register or the memory, data for the latest open-circuit voltage $OCV_A$, e.g., corresponding to time $t'_{A2}$ shown in FIG. 3. After obtaining the first open-circuit voltage $OCV_A$, the processor 228 searches the abovementioned state-of-charge lookup table rSoC (OCV) for a first state of charge $rSoC_A$ that corresponds to the first open-circuit voltage $OCV_A$. For example, the processor 228 searches the multiple data groups in the lookup table rSoC (OCV) for a corresponding data group. The corresponding data group includes a voltage value that is most close to the first open-circuit voltage $OCV_A$, compared with the other voltage values stored in the lookup table rSoC (OCV). The value of the state of charge in the corresponding data group can be considered as the first state of charge $rSoC_A$ corresponds to the first open-circuit voltage $OCV_A$. The first state of charge $rSoC_A$ can be considered to be an available state of charge of the battery 210 in the first idle state.

Similarly, as shown in FIG. 3, after entering the second idle state, the open-circuit voltage of the battery 210 gradually stabilizes. When the open-circuit voltage has stabilized, the processor 228 obtains, from the second ADC 236, a second open-circuit voltage $OCV_B$ of the battery 210 in the second idle state. For example, if the processor 228 detects that the battery 210 enters the second idle state, the processor 228 can start a timer. When a predetermined time interval T2 expires, e.g., at time $t_{A5}$, the open-circuit voltage is considered to have stabilized, and the processor 228 obtains a second open-circuit voltage $OCV_B$ from the second ADC 236. The durations of the time intervals T1 and T2 can be, but not necessarily, the same. After obtaining the second open-circuit voltage $OCV_B$, the processor 228 searches the state-of-charge lookup table rSoC (OCV) for a second state of charge $rSoC_B$ that corresponds to the second open-circuit voltage $OCV_B$. The second state of charge $rSoC_B$ can be considered to be an available state of charge of the battery 210 in the second idle state.

Additionally, as shown in FIG. 3, the battery 210 is in a continuous charging state between the first idle state and the second idle state (e.g., from time $t_{A3}$ to time $t_{A4}$). In an embodiment, a continuous charging state refers to a charging state in which a charge current of a battery is continuously greater than zero amperes. The processor 228 calculates the amount of charges, e.g., referred to as charge amount $Q(t)_{CHG}$, flowing to the battery 210 in the continuous charging state, e.g., according to the abovementioned equation (1), and updates a current full absolute charge capacity FACC of the battery 210 according to a ratio of the charge amount $Q(t)_{CHG}$ to a difference between the second state of charge $rSoC_B$ and the first state of charge $rSoC_A$.

More specifically, in an embodiment, the processor 228 calculates a current charging aging factor AFC of the battery 210 according to the following equation:

$$ AFC = \frac{Q(t)_{CHG}}{(rSoC_B - rSoC_A)} . \qquad (5) $$

The processor 228 further updates a current full absolute charge capacity FACC of the battery 210 according to the following equation:

$$ FACC = FACC_0 \times \frac{AFC}{AFC_0} . \qquad (6) $$

In equation (6), FACC represents a current full absolute charge capacity of the battery 210, $FACC_0$ represents a previous full absolute charge capacity of the battery 210, and $AFC_0$ represents a previous charging aging factor of the battery 210. The previous charging aging factor $AFC_0$ refers to a charging aging factor that is obtained by the processor 228 after a previous charging process of the battery 210. In an embodiment, the previous full absolute charge capacity $FACC_0$ refers to a full absolute charge capacity that is previously updated. In another embodiment, if the battery 210 is a new battery, the previous full absolute charge capacity $FACC_0$ refers to the aforementioned predetermined full absolute charge capacity pFACC of the battery 210.

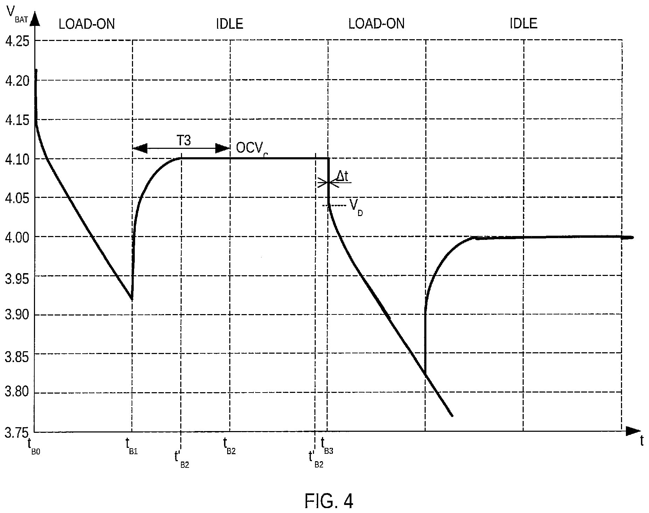

FIG. 4 illustrates an example of a plot for a voltage $V_{BAT}$ of the battery 210 in various states, in an embodiment of the present invention. FIG. 4 is described in combination with FIG. 2A and FIG. 2B to explain how to calculate a discharging aging factor AFD of the battery 210. As shown in FIG. 4, the battery 210 transitions from an idle state at time to a load-on state (or a discharging state) at time $t_{B3}$. The load-on state immediately follows the idle state.

In an embodiment, after entering the idle state, the open-circuit voltage of the battery 210 gradually stabilizes. When the open-circuit voltage of the battery 210 has stabilized (e.g., from time $t'_{B1}$ to time $t_{B3}$), the processor 228 obtains, from the second ADC 236, an open-circuit voltage OCVc of the battery 210 in the idle state. For example, if the processor 228 detects that the battery 210 enters the idle state, the processor 228 can start a timer. When a predetermined time interval T3 expires, e.g., at time $t_{B2}$, the open-circuit voltage is considered to have stabilized, and the processor 228 obtains an open-circuit voltage OCVc from the second ADC 236. For another example, when the processor 228 detects that the battery 210 transitions from the idle state to the load-on state, the processor 228 can read, from an abovementioned register or memory that records the battery voltage $V_{BAT}$, data for the latest open-circuit voltage OCVc, e.g., corresponding to time $t'_{B2}$ shown in FIG. 4.

When the battery 210 transitions from the idle state to the load-on state (e.g., at time $t_{B3}$), the battery voltage $V_{BAT}$ can rapidly drop from the open-circuit voltage OCVc to a discharge initial voltage $V_D$. The processor 228 can obtain, from the second ADC 236, the discharge initial voltage $V_D$ and a discharge current $I_{DIS}$ of the battery 210 in the load-on state. More specifically, the processor 228 can receive, from the second ADC 236, a signal 214 indicative of the initial discharge voltage $V_D$ and a signal 216 indicative of the discharge current $I_{DIS}$. For example, the processor 228 can start a timer when it detects that the battery 210 transitions from an idle state to a load-on state, e.g., at time $t_{B3}$. When a preset time interval $\Delta t$ (e.g., 3 ms, 4 ms, or the like) expires, the processor 228 obtains a battery voltage $V_D$. That battery voltage $V_D$ can be considered to be an initial discharge voltage $V_D$ of the battery 210 in the load-on state. Additionally, the processor 228 obtains a discharge current $I_{DIS}$ of the battery 210 from the second ADC 236. In an embodiment, the preset time interval $\Delta t$ is greater than the time that is required for the battery voltage $V_{BAT}$ to drop from the open-circuit voltage OCVc to the initial discharge voltage $V_D$, and the preset time interval $\Delta t$ is relatively small (e.g., less than 5ms) so that a difference between the actual initial discharge voltage $V_D$ and the initial discharge voltage $V_D$ is relatively small and can be ignored. For another example, the processor 228 (or other circuitry in the battery management system 200A or 200B) can detect a rate of change $dV_{BAT}/dt$ in the battery voltage $V_{BAT}$. At the moment when the battery 210 transitions from the idle state to the load-on state, the rate of change $dV_{BAT}/dt$ can be relatively large. When the battery voltage $V_{BAT}$ drops to the initial discharge voltage $V_D$, the rate of change $dV_{BAT}/dt$ can decrease. When the processor 228 (or the other circuitry) detects that the rate of change $dV_{BAT}/dt$ is less than a preset threshold, the processor 228 can obtain a battery voltage $V_D$ at that moment, and that battery voltage $V_D$ can be considered to be an initial discharge voltage $V_D$ of the battery 210 in the load-on state.

In an embodiment, the processor 228 updates a current full absolute charge capacity FACC of the battery 210 according to the discharge current $I_{DIS}$ and a difference between the discharge initial voltage $V_D$ and the open-circuit voltage OCVc.

More specifically, the processor 228 calculates a current discharging aging factor AFD according to the following equation:

$$AFD = \frac{(V_D - OCV_C)}{I_{DIS}}. \tag{7}$$

The processor 228 further updates the current full absolute charge capacity FACC according to the following equation:

$$FACC = FACC_0 \times \frac{AFD}{AFD_0}. \tag{8}$$

In equation (8), FACC represents a current full absolute charge capacity of the battery 210, $FACC_0$ represents a previous full absolute charge capacity of the battery 210, and $AFD_0$ represents a previous discharging aging factor of the battery 210. The previous discharging aging factor $AFD_0$ refers to a discharging aging factor that is obtained by the processor 228 during or after a previous discharging process of the battery 210.

As mentioned above, in an embodiment, the processor 228 can update the full absolute charge capacity FACC of the battery 210 according to the charging aging factor AFC and equation (6). In another embodiment, the processor 228 can update the full absolute charge capacity FACC of the battery 210 according to the discharging aging factor AFD and equation (8). Additionally, in yet another embodiment, the processor 228 can update the full absolute charge capacity FACC according to the charging aging factor AFC and the discharging aging factor AFD based on a specific function, e.g., equation (9) as follows.

$$FACC = f(AFC, AFD, FACC_0) \tag{9}$$

For example, the processor 228 can update the current full absolute charge capacity FACC according to the following equation:

$$FACC = \alpha \times FACC_0 \times \frac{AFC}{AFC_0} + \beta \times FACC_0 \times \frac{AFD}{AFD_0}. \tag{10}$$

In equation (10), $\alpha$ and $\beta$ are weighting factors less than 1, and the sum of $\alpha$ and $\beta$ is equal to 1, e.g., $\alpha+\beta=1$. Equation (10) is an example for explanation purposes, and is not intended to limit the invention.

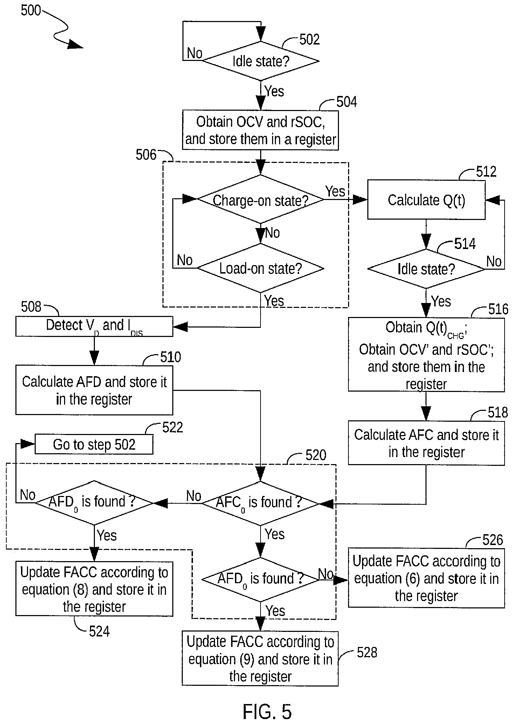

FIG. 5 illustrates a flowchart 500 of an example of a method for updating a full absolute charge capacity FACC of the battery 210, in an embodiment of the present invention. Although specific steps are disclosed in FIG. 5, such steps are examples for illustrative purposes. That is, embodiments according to the present invention are well suited to performing various other steps or variations of the steps recited in FIG. 5. FIG. 5 is described in combination with FIG. 2A, FIG. 2B, FIG. 3 and FIG. 4.

As shown in FIG. 5, at step 502, the processor 228 detects whether the battery 210 enters an idle state. If the battery 210 enters an idle state, the flowchart 500 goes to step 504. At step 504, the processor 228 obtains an open-circuit voltage OCV of the battery 210 in the idle state, obtains a corresponding state of charge rSoC from the state-of-charge lookup table rSoC (OCV), and stores the open-circuit voltage OCV and the state of charge rSoC in a register.

At step 506, the processor 228 detects whether the battery 210 transitions from the idle state to a charging state or a load-on state. If the battery 210 transitions from the idle state to a charging state, then the flowchart 500 goes to step 512. If the battery 210 transitions from the idle state to a load-on state, then the flowchart 500 goes to step 508.

At step 508, the processor 228 detects/obtains an initial discharge voltage $V_D$ and a discharge current $I_{DIS}$ of the battery 210 in the load-on state. At step 510, the processor 228 calculates a discharging aging factor AFD according to the discharge initial voltage $V_D$, the discharge current $I_{DIS}$, and the open-circuit voltage OCV obtained in step 504 based on equation (7), e.g., AFD = $(V_D-OCV)/I_{DIS}$, and stores the discharging aging factor AFD in the register.

At step 512, the processor 228 calculates the amount of charges $Q(t)_{CHG}$ flowing through the battery 210 in the charging state. At step 514, if the processor 228 detects that the battery 210 transitions from the charging state to another idle state, then the flowchart 500 goes to step 516. At step 516, the processor 228 obtains the charge amount $Q(t)_{CHG}$ of the battery 210, obtains the open-circuit voltage OCV' and the state of charge rSoC' of the battery 210 in the current idle state, and stores the open-circuit voltage OCV' and the state of charge rSoC' in a register. At step 518, the processor 228 calculates a charging aging factor AFC according to the charge amount $Q(t)_{CHG}$ and the state of charge rSoC' obtained at step 516, and according to a previously stored state of charge rSoC (e.g., AFC = $Q(t)_{CHG}$/(rSoC'-rSoC)). The processor 228 further stores the calculated charging aging factor AFC in the register.

At step 520, the processor 228 searches the register to determine whether there are a previous charging aging factor $AFC_0$ and/or a previous discharging aging factor $AFD_0$ stored in the register.

If no previous charging aging factor $AFC_0$ nor previous discharging aging factor $AFD_0$ are found in the register, then the flowchart 500 goes to step 522 to repeat the flowchart 500.

If a previous discharging aging factor $AFD_0$ is found in the register, and no previous charging aging factor $AFC_0$ is found, then the flowchart 500 goes to step 524. At step 524, the processor 228 updates a current full absolute charge capacity FACC of the battery 210 according to equation (8), and stores the updated current full absolute charge capacity FACC in the register.

If a previous charging aging factor $AFC_0$ is found in the register, and no previous discharging aging factor $AFD_0$ is found, then the flowchart 500 goes to step 526. At step 526, the processor 228 updates a current full absolute charge capacity FACC of the battery 210 according to equation (6), and stores the updated current full absolute charge capacity FACC in the register.

If a previous charging aging factor $AFC_0$ and a previous discharging aging factor $AFD_0$ are found in the register, then the flowchart 500 goes to step 528. At step 528, the processor 228 updates a current full absolute charge capacity FACC of the battery 210 according to equation (9), and stores the updated current full absolute charge capacity FACC in the register.

Accordingly, an embodiment according to the present invention provides a method of updating a current full absolute charge capacity FACC of the battery 210 based on aging factors of the battery 210, thereby obtaining a more accurate current full available charge capacity DFC and a more accurate current available state of charge rSoC of the battery 210.

As mentioned above, in an embodiment, during a discharging process, the temperature of the battery 210 can increase when the discharge current $I_{DIS}$ is relatively large. Thus, the processor 228 is configured to estimate an end-of-discharge temperature $T_{EOD}$ of the battery 210. In one such embodiment, the EOD remaining capacity $aRC_{EOD}$ of the battery 210 in equation (2c) is obtained by searching the lookup table aRC (V, I, T) for a remaining capacity that corresponds to an end-of-discharge voltage $V_{EOD}$, a current battery current $I_N$, and the end-of-discharge temperature $T_{EOD}$.

$$aRC_{EOD} = f(V_{EOD}, I_N, T_{EOD}) \qquad (11)$$

Similarly, the EOD state of charge $aSoC_{EOD}$ of the battery 210 in equation (4a) is obtained by searching the lookup table aRC (V, I, T) for a state of charge that corresponds to an end-of-discharge voltage $V_{EOD}$, a current battery current $I_N$, and the end-of-discharge temperature $T_{EOD}$.

$$aSOC_{EOD} = f(V_{EOD}, I_N, T_{EOD}). \qquad (12)$$

As a result, the processor 228 can obtain a more accurate full available charge capacity DFC as well as a more accurate available state of charge $rSoC_N$ of the battery 210.

In an embodiment, a method of estimating an end-of-discharge temperature $T_{EOD}$ of the battery 210 involves multiple parameters, e.g., including a total discharge time $\Delta t_{TOT}$, a discharge rate $RI_{DIS}$, a discharged energy $E_{DIS}$, an equivalent heat capacity factor $K_N$, etc. More specifically, in an embodiment, a total discharge time $\Delta t_{TOT}$ of a battery includes an absolute total discharge time $\Delta t_{TOT\_A}$ and an available total discharge time $\Delta t_{TOT\_R}$. The absolute total discharge time $\Delta t_{TOT\_A}$ refers to the time for the battery to discharge from a fully charged state to a fully discharged state. The available total discharge time $\Delta t_{TOT\_R}$ refers to the time for the battery to discharge from a fully charged state to an end-of-discharge state. The available total discharge time $\Delta t_{TOT\_R}$ is less than the absolute total discharge time $\Delta t_{TOT\_A}$.

In an embodiment, when a battery is discharged, parameters that reflect a situation of discharging of the battery includes a discharge current $I_{DIS}$ and a discharge rate $RI_{DIS}$. The discharge rate $RI_{DIS}$ can be referred to as "C-rate." A C-rate is a measure of the rate at which a battery is discharged relative to its maximum capacity (e.g., a full absolute charge capacity FACC). A 1C rate means that the discharge current $I_{DIS}$ will discharge the entire battery in 1 hour. A 2C rate means that the discharge current will discharge the entire battery in 30 minutes. In other words, if the discharge rate $RI_{DIS}$ is 1C, then the absolute total discharge time $\Delta t_{TOT\_A}$ of the battery is 1 hour. Similarly, if the discharge rate $RI_{DIS}$ is 2C, then the absolute total discharge time $\Delta t_{TOT\_A}$ of the battery is 30 minutes. In an embodiment, the discharge rate $RI_{DIS}$ can be obtained by calculation based on the discharge current $I_{DIS}$ and the full absolute charge capacity FACC, e.g., $RI_{DIS} = I_{DIS} \times (1hour/FACC)$. In another embodiment, the discharge rate $RI_{DIS}$ can be obtained by reading information in an instruction provided by a user. For example, a high power machine such as a portable vacuum can have a few power levels for a user to select. The power levels may include a lower power level corresponding to 1C rate of discharge, a medium power level corresponding to 2C rate of discharge, and a higher power level corresponding to 4C rate of discharge. Thus, the current discharge rate $RI_{DIS}$ can be obtained by reading the instruction information for the power level that is selected by the user.

In an embodiment, a discharged energy $E_{DIS}$ refers to the amount of energy released from a battery because of being discharged. The discharged energy $E_{DIS}$ can be given by:

$$E_{DIS} = \int_{t1}^{t2} P_{DIS} dt. \qquad (13a)$$

In equation (13a), $P_{DIS}$ represents a discharge power of the battery. In an embodiment, if the discharge current $I_{DIS}$ of the battery is relatively stable, then the discharge power can be given by: $P_{DIS} = I_{DIS} \times V_{NOM}$, where $V_{NOM}$ represents a nominal voltage of the battery. Thus, equation (13a) can be simplified as follows:

$$E_{DIS} = I_{DIS} \times V_{NOM} \times \Delta t_{DIS}. \qquad (13b)$$

In equation (13b), $\Delta t_{DIS}$ represents a discharge time of the battery, e.g., $\Delta t_{DIS} = t2-t1$.

In an embodiment, the amount of change $\Delta T$, e.g., increment, of a battery's temperature can be determined by a discharged energy $E_{DIS}$ and an equivalent heat capacity factor $K_N$ of the battery. More specifically, the temperature change $\Delta T$, e.g., increment, in the battery's temperature can be given by:

$$\Delta T = K_N \times E_N. \qquad (14)$$

Additionally, in an embodiment, the equivalent heat capacity factor $K_N$ of the battery has a specific relationship with the discharge current $I_{DIS}$ of the battery, and can be given by a function as follows:

$$K_N = f(I_{DIS}). \qquad (15)$$

In an embodiment, the function (15) can be obtained based on experimental data.

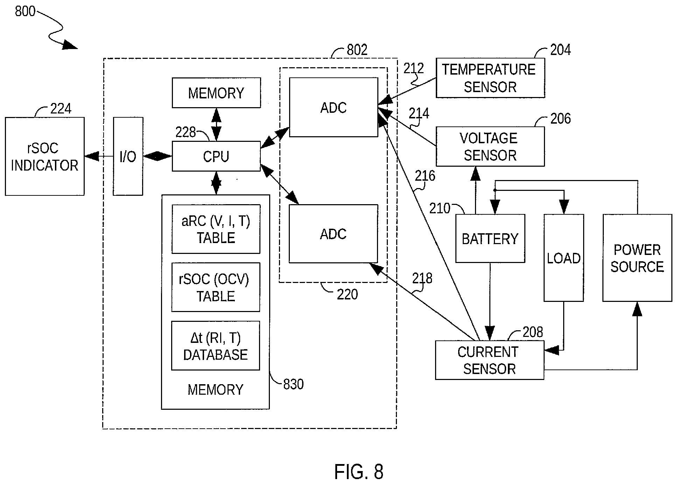

FIG. 6A, FIG. 6B, FIG. 6C and FIG. 6D illustrate examples of plots for temperature changes in different situations based on examples of experimental data, in embodiments of the present invention. Taking FIG. 6A for example, line 642 shows the change in the battery's temperature in a situation in which a fully charged battery discharges at a discharge rate of 0.8C (e.g., $RI_{DIS}$ = 0.8C), and the initial battery's temperature is 5 °C; and line 644 shows the change in the battery's temperature in a situation in which the fully charged battery discharges at a discharge rate of 0.8C, and the initial battery's temperature is 25 °C. Taking FIG. 6B for another example, line 646 shows the change in the battery's temperature in a situation in which the fully charged battery discharges at a discharge rate of 1.2C, and the initial battery's temperature is 15 °C. In an embodiment, a discharge time database $\Delta t$ ($RI_{DIS}$, $T_{INITIAL}$) can be established based on experimental data at various discharge rate, e.g., 0.4C, 0.8C, ..., 4C, etc., and at different initial temperature, e.g., 5 °C, 10 °C, ..., 45 °C, etc. The discharge time database $\Delta t$ ($RI_{DIS}$, $T_{INITIAL}$) can also be referred to as a cell temperature adjustment table. The discharge time database $\Delta t$ ($RI_{DIS}$, $T_{INITIAL}$) can be stored in a memory, e.g., the memory 830 shown in FIG. 8.

More specifically, in an embodiment, the discharge time database $\Delta t$ ($RI_{DIS}$, $T_{INITIAL}$) includes multiple sets of data. Each set of data is corresponding to a discharge rate $RI_{DIS}$ and an initial temperature $T_{INITIAL}$. For example, as shown in FIG. 6A, line 642 represents a set of data corresponding to a discharge rate of 0.8C and an initial temperature of 5 °C, and line 644 represents a set of data corresponding to a discharge rate of 0.8C and an initial temperature of 25 °C. For another example, as shown in FIG. 6B, line 646 represents a set of data corresponding to a discharge rate of 1.2C and an initial temperature of 15°C. Thus, each set of data includes information for a discharge rate and an initial temperature. Additionally, each set of data includes information for an available total discharge time $\Delta t_{TOT\_R}$. For example, as shown in FIG. 6A, if the battery is discharged at 0.8C rate, and the initial battery's temperature is 5 °C, then the available total discharge time $\Delta t_{TOT\_R}$ of the battery can be 3843 seconds. For another example, as shown in FIG. 6B, if the battery is discharged at 1.2C rate, and the initial battery's temperature is 15 °C, then the available total discharge time $\Delta t_{TOT\_R}$ of the battery can be 2719 seconds. Moreover, each set of data can, but not necessarily, include voltage values of the battery's voltage, and coulomb values of the charges discharged from the battery at different time points (e.g., from the time point when the battery starts to discharge to the time point when the battery enters the end-of-discharge state).

In an embodiment, the battery 210 is fully charged when the battery 210 starts to discharge. In one such embodiment, the processor 228 can obtain a current battery discharge rate $RI_{DIS}$ and a current battery temperature $T_N$, and search the discharge time database $\Delta t$ ($RI_{DIS}$, $T_{INITIAL}$) for an available total discharge time $\Delta t_{TOT\_R}$ that corresponds to the current battery discharge rate $RI_{DIS}$ and the current battery temperature $T_N$, e.g., $\Delta t_{TOT\_R}$ = f($RI_{DIS}$, $T_N$). The processor 228 can estimate the amount of energy, e.g., a discharged energy $E_{DIS}$, that will be released from the battery 210 when the battery 210 discharges from the fully charged state to the end-of-discharge state, according to the available total discharge time $\Delta t_{TOT\_R}$ and equation (13a), e.g., $E_{DIS} = I_{DIS} \times V_{NOM} \times \Delta t_{TOT\_R}$. The processor 228 can also obtain an equivalent heat capacity factor $K_N$ of the battery 210 based on equation (15), e.g., $K_N$ = f($I_{DIS}$), and estimate a temperature change $\Delta T_{EOD}$ of the battery 210 based on equation (14), e.g., $\Delta T_{EOD} = K_N \times E_{DIS}$. As a result, the processor 228 can estimate an end-of-discharge temperature $T_{EOD}$ of the battery 210 by adding the temperature change $\Delta T_{EOD}$ to the current battery temperature $T_N$, e.g., $T_{EOD} = T_N + \Delta T_{EOD}$.

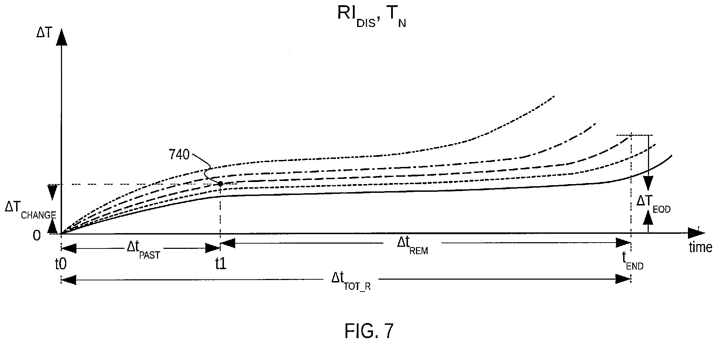

In another embodiment, the battery 210 is not fully charged when the battery 210 starts to discharge. In one such embodiment, an example of a method of estimating an end-of-discharge temperature $T_{EOD}$ of the battery 210 is described in combination with FIG. 7, FIG. 8 and FIG. 9A.

In the example of FIG. 7, dot 740 is assumed to represent a situation in which the battery 210 starts to discharge. More specifically, the battery 210 starts to discharge at time point t1, at a current discharge rate of $RI_{DIS}$, and at a current temperature of $T_N$. Assuming that the battery 210 is being discharged at the discharge rate $RI_{DIS}$ for a while before the current time point t1, then the parameter $\Delta t_{PAST}$ shown in FIG. 7 represents an assumed past time from an assumed initial time point t0 when the battery 210 is fully charged and starts to discharge at the discharge rate $RI_{DIS}$ to the current time point t1. The processor 228 can estimate the assumed past time $\Delta t_{PAST}$ according to a current absolute state of charge $aSoC_N$ and the current discharge rate $RI_{DIS}$. Based on the assumed past time $\Delta t_{PAST}$, the processor 228 can estimate an assumed initial temperature $T_{INITIAL}$ of the battery 210 at the assumed initial time point t0. Accordingly, the processor 228 can search the discharge time database $\Delta t$ ($RI_{DIS}$, $T_{INITIAL}$) for an assumed available total discharge time $\Delta t_{TOT\_R}$ that corresponds to the current discharge rate $RI_{DIS}$ and the assumed initial temperature $T_{INITIAL}$, thereby estimating an end-of-discharge temperature $T_{EOD}$ of the battery 210 according to the assumed available total discharge time $\Delta t_{TOT\_R}$.

FIG. 8 illustrates a block diagram of an example of a battery management system 800, in an embodiment of the present invention. FIG. 8 is described in combination with FIG. 2A, FIG. 2B, FIG. 3, FIG. 4, FIG. 5, FIG. 6A, FIG. 6B, FIG. 6C, FIG. 6D and FIG. 7. In the example of FIG. 8, the battery management controller 802 is similar to the battery management controller 202 in FIG. 2A or FIG. 2B except that the battery management controller 802 further includes an abovementioned discharge time database $\Delta t$ ($RI_{DIS}$, $T_{INITIAL}$) stored in a memory, e.g., the memory 830 shown in FIG. 8. The processor 228 can estimate an end-of-discharge temperature $T_{EOD}$ of the battery 210 based on the database $\Delta t$ ($RI_{DIS}$, $T_{INITIAL}$).

FIG. 9A illustrates a flowchart 900A of an example of a method of estimating an end-of-discharge temperature $T_{EOD}$ of the battery 210, in an embodiment of the present invention. Although specific steps are disclosed in FIG. 9A, such steps are examples for illustrative purposes. That is, embodiments according to the present invention are well suited to performing various other steps or variations of the steps recited in FIG. 9A. FIG. 9A is described in combination with FIG. 2A, FIG. 2B, FIG. 3, FIG. 4, FIG. 5, FIG. 6A, FIG. 6B, FIG. 6C, FIG. 6D, FIG. 7 and FIG. 8.

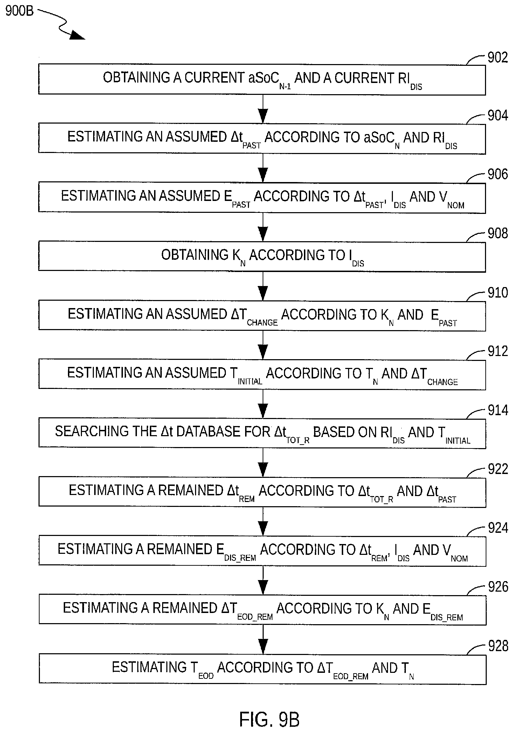

As shown in FIG. 9, at step 902, the processor 228 obtains a current absolute state of charge $aSoC_N$ and a current discharge rate $RI_{DIS}$. As mentioned above, in an embodiment, the processor 228 can obtain the current absolute state of charge $aSoC_N$ by searching the lookup table aRC (V, I, T) for a state of charge that corresponds to a current battery voltage $V_N$, a current battery current $I_N$, and a current battery temperature $T_N$ of the battery 210. In an embodiment, the processor 228 can obtain the current discharge rate $RI_{DIS}$ by reading information in an instruction provided by a user, or by doing calculation based on a current discharge current of the battery 210.

At step 904, the processor 228 estimates an assumed past time $\Delta t_{PAST}$ according to the current absolute state of charge $aSoC_N$ and the current discharge rate $RI_{DIS}$. For example, the assumed past time $\Delta t_{PAST}$ can be given by: $\Delta t_{PAST} = (100\% - aSoC_N)/RI_{DIS}$. As mentioned above, in an embodiment, the time $\Delta t_{PAST}$ represents an assumed past time from an assumed initial time point t0 when the battery 210 is fully charged and starts to discharge at the discharge rate $RI_{DIS}$ to a current time point t1.

At step 906, the processor 228 estimates an assumed discharged energy $E_{PAST}$ according to the assumed past time $\Delta t_{PAST}$, a current discharge current $I_{DIS}$ of the battery 210, and a nominal voltage $V_{NOM}$ of the battery 210. The assumed discharged energy $E_{PAST}$ refers to an amount of energy that is assumed to be released from the battery 210 during the assumed past time $\Delta t_{PAST}$. Based on equation (13b), the assumed discharged energy $E_{PAST}$ can be given by: $E_{PAST} = I_{DIS} \times V_{NOM} \times \Delta t_{PAST}$.

At step 908, the processor 228 obtains an equivalent heat capacity factor $K_N$ of the battery 210 according to the discharge current $I_{DIS}$ based on equation (15).

At step 910, the processor 228 estimates an assumed temperature change $\Delta T_{CHANGE}$ of the battery 210 according to the equivalent heat capacity factor $K_N$ and the assumed discharged energy $E_{PAST}$. The assumed temperature change $\Delta T_{CHANGE}$ refers to the change in the battery temperature from the assumed initial time point t0 to the current time point t1. Based on equation (14), the assumed temperature change $\Delta T_{CHANGE}$ can be given by: $\Delta T_{CHANGE} = K_N \times E_{PAST}$.

At step 912, the processor 228 estimates an assumed initial temperature $T_{INITIAL}$ of the battery 210 at the assumed initial time point t0 according to a current battery temperature $T_N$ of the battery 210 and the assumed temperature change $\Delta T_{CHANGE}$, e.g., $T_{INITIAL} = T_N - \Delta T_{CHANGE}$.

At step 914, the processor 228 searches the discharge time database $\Delta t$ ($RI_{DIS}$, $T_{INITIAL}$) for an assumed available total discharge time $\Delta t_{TOT\_R}$ that corresponds to the current discharge rate $RI_{DIS}$ and the assumed initial temperature $T_{INITIAL}$, e.g., $\Delta t_{TOT\_R} = f(RI_{DIS}, T_{INITIAL})$. For example, the processor 228 can search the multiple sets of data in the discharge time database $\Delta t$ ($RI_{DIS}$, $T_{INITIAL}$) for a corresponding set of data. The corresponding set of data includes a discharge rate and an initial temperature that match the current discharge rate $RI_{DIS}$ and the assumed initial temperature $T_{INITIAL}$. If the corresponding set of data is found, then the available total discharge time in the corresponding set of data can be considered as the assumed available total discharge time $\Delta t_{TOT\_R}$. If the corresponding set of data is found, then the processor 228 can perform linear interpolation to estimate the available total discharge time $\Delta t_{TOT\_R}$ based on the data in the discharge time database $\Delta t$ ($RI_{DIS}$, $T_{INITIAL}$).

At step 916, the processor 228 estimates a total discharged energy $E_{DIS}$ according to the assumed available total discharge time $\Delta t_{TOT\_R}$, the current discharge current $I_{DIS}$, and the nominal voltage $V_{NOM}$. The total discharged energy $E_{DIS}$ refers to the total amount of energy released from the battery 210 during the assumed available total discharge time $\Delta t_{TOT\_R}$. Based on equation (13b), the total discharged energy $E_{DIS}$ can be given by: $E_{DIS} = I_{DIS} \times V_{NOM} \times \Delta t_{TOT\_R}$.

At step 918, the processor 228 estimates a total temperature change $\Delta T_{EOD}$ according to the equivalent heat capacity factor $K_N$ and the total discharged energy $E_{DIS}$. The total temperature change $\Delta T_{EOD}$ refers to the change in the battery 210 from the assumed initial time point t0 to the end-of-discharge time point $t_{END}$ when the battery 210 enters an end-of-discharge state. Based on equation (14), the total temperature change $\Delta T_{EOD}$ can be given by: $\Delta T_{EOD} = K_N \times E_{DIS}$.

At step 920, the processor 228 estimates an end-of-discharge temperature $T_{EOD}$ of the battery 210 according to the total temperature change $\Delta T_{EOD}$ and the assumed initial temperature $T_{INITIAL}$, e.g., $T_{EOD} = T_{INITIAL} + \Delta T_{EOD}$.

FIG. 9B illustrates a flowchart 900B of another example of a method of estimating an end-of-discharge temperature $T_{EOD}$ of the battery 210, in an embodiment of the present invention. Although specific steps are disclosed in FIG. 9B, such steps are examples for illustrative purposes. That is, embodiments according to the present invention are well suited to performing various other steps or variations of the steps recited in FIG. 9A. FIG. 9B is described in combination with FIG. 2A, FIG. 2B, FIG. 3, FIG. 4, FIG. 5, FIG. 6A, FIG. 6B, FIG. 6C, FIG. 6D, FIG. 7, FIG. 8 and FIG. 9A. As shown in FIG. 9B, the flowchart 900B is similar to the flowchart 900A in FIG. 9A except that, the steps 916, 918 and 920 in FIG. 9A are replaced by the steps 922, 924, 926 and 928 in FIG. 9B.

More specifically, in the example of FIG. 9B, the flowchart 900B goes to step 922 following step 914. At step 922, the processor 228 estimates a remained time $\Delta t_{REM}$ according to the assumed available total discharge time $\Delta t_{TOT\_R}$ and the assumed past time $\Delta t_{PAST}$, e.g., $\Delta t_{REM} = \Delta t_{TOT\_R} - \Delta t_{PAST}$. The remained time $\Delta t_{REM}$ refers an estimated time for the battery 210 to discharge from the current time point t1 to the end-of-discharge time point $t_{END}$ when the battery 210 enters an end-of-discharge state.

At step 924, the processor 228 estimates a remained discharged energy $E_{DIS\_REM}$ according to the remained time $\Delta t_{REM}$, the current discharge current $I_{DIS}$, and the nominal voltage $V_{NOM}$ of the battery 210. The remained discharged energy $E_{DIS\_REM}$ refers to an estimated amount of energy that will be released from the battery 210 during the remained time $\Delta t_{REM}$. Based on equation (13b), the remained discharged energy $E_{DIS\_REM}$ can be given by: $E_{DIS\_REM} = I_{DIS} \times V_{NOM} \times \Delta t_{REM}$.

At step 926, the processor 228 estimates a remained temperature change $\Delta T_{EOD\_REM}$ according to the equivalent heat capacity factor $K_N$ and the remained discharged energy $E_{DIS\_REM}$. The remained temperature change $\Delta T_{EOD\_REM}$ refers to the change in the battery 210 from the current time point t1 to the end-of-discharge time point $t_{END}$ when the battery 210 enters an end-of-discharge state. Based on equation (14), the remained temperature change $\Delta T_{EOD\_REM}$ can be given by: $\Delta T_{EOD\_REM} = K_N \times E_{DIS\_REM}$.

At step 928, the processor 228 estimates an end-of-discharge temperature $T_{EOD}$ of the battery 210 according to the remained temperature change $\Delta T_{EOD\_REM}$ and the current temperature $T_N$, e.g., $T_{EOD} = T_B + \Delta T_{EOD\_REM}$.

Accordingly, in an embodiment, the processor 228 can estimate an assumed initial temperature $T_{INITIAL}$ of the battery 210 based on a current absolute state of charge $aSoC_N$ of the battery 210 and a current discharge rate $RI_{DIS}$ of the battery 210. Additionally, the processor 228 can search the discharge time database $\Delta t (RI_{DIS}, T_{INITIAL})$ for an assumed available total discharge time $\Delta t_{TOT\_R}$ that corresponds to the current discharge rate $RI_{DIS}$ and the assumed initial temperature $T_{INITIAL}$. Moreover, the processor 228 can estimate an end-of-discharge temperature $T_{EOD}$ of the battery 210 according to the assumed available total discharge time $\Delta t_{TOT\_R}$.

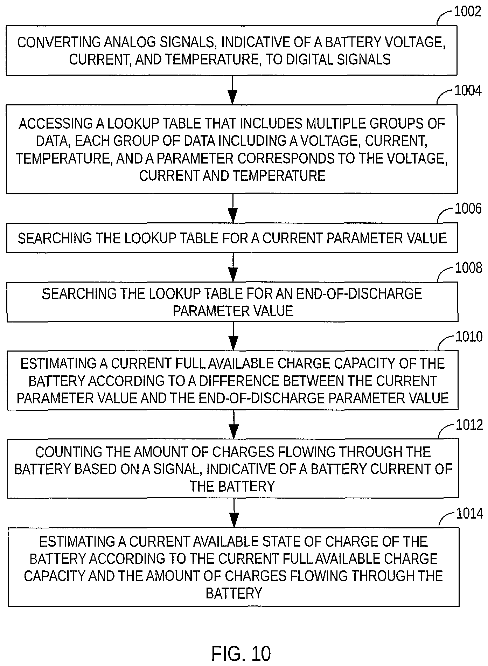

FIG. 10 illustrates an example of a method for estimating an available state of charge of a battery, in an embodiment of the present invention. Although specific steps are disclosed in FIG. 10, such steps are examples for illustrative purposes. That is, embodiments according to the present invention are well suited to performing various other steps or variations of the steps recited in FIG. 10. FIG. 10 is described in combination with FIG. 2A, FIG. 2B, FIG. 3, FIG. 4, FIG. 5, FIG. 6A, FIG. 6B, FIG. 6C, FIG. 6D, FIG. 7, FIG. 8, FIG. 9A and FIG. 9B.

At step 1002, the analog-to-digital conversion circuitry 220 converts analog signals 214, 216 and 222, indicative of a current battery voltage $V_N$, a current battery current $I_N$, and a current battery temperature $T_N$ of the battery 210, to computer-readable digital signals 234.

At step 1004, the processor 228 accesses to the remaining-capacity lookup table aRC (V, I, T) stored in the memory 230. The remaining-capacity lookup table aRC (V, I, T) includes multiple groups of data. Each group includes data for a voltage V, a current I, a temperature T, and a parameter associated with a remaining capacity aRC that corresponds to the voltage V, current I and temperature T. The parameter can include an absolute remaining capacity aRC and/or an absolute state of charge aSoC (e.g., aSoC=aRC/pFACC).

More specifically, at step 1006, the processor 228 searches the remaining-capacity lookup table aRC (V, I, T) for a current parameter value, e.g., a current absolute remaining capacity $aRC_N$ or a current absolute state of charge aSoC of the battery 210, that corresponds to a current battery voltage $V_N$, a current battery current $I_N$, and a current battery temperature $T_N$ according the digital signals 234, e.g., $aRC_N = f(V_N, I_N, T_N)$.

At step 1008, the processor 228 searches the remaining-capacity lookup table aRC (V, I, T) for an end-of-discharge parameter value, e.g., an EOD reaming capacity $aRC_{EOD}$ or an EOD state of charge $aSoC_{EOD}$, that corresponds to an end-of-discharge voltage $V_{EOD}$, the current battery current $I_N$, and an end-of-discharge temperature $T_{EOD}$.

At step 1010, the processor 228 estimates a current full available charge capacity DFC of the battery 210 according to a difference between the current parameter value (e.g., $aRC_N$ or aSoC) and the end-of-discharge parameter value (e.g., $aRC_{EOD}$ or $aSoC_{EOD}$). Examples are provided in the descriptions related to the abovementioned equations (2c) and (4a).

At step 1012, the processor 228 counts the amount of charges Q(t) based on a signal (e.g., the signal 232A in FIG. 2A or the signal 232B in FIG. 2B), indicative of a battery current of the battery 210, received from the analog-to-digital conversion circuitry 220.

At step 1014, the processor 228 estimates a current available state of charge $rSoC_N$ of the battery 210 according to the full available charge capacity DFC and the amount of charges Q(t) flowing through the battery 210.

In summary, embodiments according to the present invention provide battery management controllers to estimate a current available state of charge $rSOC_N$ of a battery. The controller can count the amount of charges Q(t) flowing through the battery based on coulomb counting. The controller can also estimate a current full available charge capacity DFC of the battery based on parameter values obtained from a remaining-capacity lookup table. The controller can further estimate the current available state of charge $rSOC_N$ of the battery according to the amount of charges Q(t) and the current full available charge capacity DFC. In other words, the current available state of charge $rSOC_N$ of the battery can be obtained by combining the coulomb counting with the remaining-capacity lookup table. As a result, the abrupt change in the estimated value of the available state of charge that exists in the prior art can be eliminated in an embodiment of the present invention. Moreover, the controller can estimate aging factors, e.g., including a charging aging factor AFC and a discharging aging factor AFD, of the battery, and update a full absolute charge capacity FACC of the battery based on the aging factors, such that the estimation of the available state of charge $rSOC_N$ of the battery can be more accurate. Furthermore, the controller can estimate an end-of-discharge temperature $T_{EOD}$ of the battery based on a discharge time database, a discharge rate $RI_{DIS}$ of the battery, and a current temperature $T_N$ of the battery, thereby obtaining a more accurate current full available charge capacity DFC. As a result, the accuracy of the estimation of the available state of charge $rSOC_N$ of the battery can be further improved.

While the foregoing description and drawings represent embodiments of the present invention, it will be understood that various additions, modifications and substitutions may be made therein without departing from the scope of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the scope of the present invention as defined in the accompanying claims. The presently disclosed embodiments are therefore to be considered in all respects as illustrative and not restrictive, the scope of the invention being indicated by the appended claims.

**Claims**

1. A battery management controller (202, 802) comprising:

   analog-to-digital conversion circuitry (220) configured to convert analog signals (214, 216, 222), indicative of a current battery voltage ($V_N$), a current battery current ($I_N$), and a current battery temperature ($T_N$) of a battery, to digital signals (234);
   a memory (230) configured to store a remaining-capacity lookup table (aRC (V, I, T)) that comprises a plurality of groups of data, wherein each group of said groups of data includes a voltage (V), a current (I), a temperature (T), and a parameter (aRC, aSoC) associated with a remaining capacity (aRC) that corresponds to said voltage (V), said current (I) and said temperature (T); and
   a processor (228), coupled to said analog-to-digital conversion circuitry (220) and said memory, and configured to receive a signal (232A, 232B), indicative of a battery current ($I_{BAT}$), from said analog-to-digital conversion circuitry (220) thereby counting the amount of charges (Q(t)) flowing through said battery, configured to search said remaining-capacity lookup table (aRC (V, I, T)) for a current parameter value ($aRC_N$, $aSoC_N$)corresponding to said current battery voltage ($V_N$), said current battery current ($I_N$), and said current battery temperature ($T_N$) according said digital signals (234), configured to search said remaining-capacity lookup table (aRC (V, I, T)) for an end-of-discharge parameter value ($aRC_{EOD}$, $aSoC_{EOD}$) corresponding to an end-of-discharge voltage ($V_{EOD}$) indicative for entering an end-of-discharge state to protect the battery from over-discharging, said current battery current ($I_N$), and an end-of-discharge temperature ($T_{EOD}$), configured to estimate a current full available charge capacity (DFC) of said battery according to a difference between said current parameter value($aRC_N$, $aSoC_N$) and said end-of-discharge parameter value ($aRC_{EOD}$, $aSoC_{EOD}$), and configured to estimate a current available state of charge ($rSOC_N$ ) of said battery according to said current full available charge capacity (DFC) and said amount of charges (Q(t)) flowing through said battery.

2. The battery management controller (202, 802) of claim 1, wherein said parameter (aRC, aSoC) comprises a state of charge (aSoC), said current parameter value ($aSoC_N$, $aSoC_N$) comprises a current absolute state of charge ($aSoC_N$) of said battery, and said end-of-discharge parameter value ($aRC_{EOD}$, $aSoC_{EOD}$) comprises an end-of-discharge (EOD) state of charge ($aSoC_{EOD}$) of said battery, and wherein said processor is configured to estimate said current full available charge capacity (DFC) according to the following equation:

$$DFC = FACC \times (aSOC_N - aSOC_{EOD})/rSOC_{N-1},$$

   where DFC represents said current full available charge capacity, FACC represents a current full absolute charge capacity of said battery, $aSOC_N$ represents said current absolute state of charge, and $aSOC_{EOD}$ represents said end-of-discharge state of charge, and $rSOC_{N-1}$ represents a previously estimated available state of charge of said battery.

3. The battery management controller (202, 802) of claim 2, wherein said processor is configured to estimate said current available state of charge ($rSOC_N$) according to the following equation:

$$rSOC_N = [(DFC \times rSOC_{N-1}) + Q(t)]/DFC,$$

   where $rSOC_N$ represents said current available state of charge, and Q(t) presents said amount of charges flowing through said battery.

4. The battery management controller (202, 802) of claim 1, wherein said parameter (aRC, aSoC) comprises a remaining capacity (aRC), said current parameter value ($aRC_N$, $aSoC_N$) comprises a current absolute remaining capacity ($aRC_N$) of said battery, and said end-of-discharge parameter value ($aRC_{EOD}$, $aSoC_{EOD}$) comprises an end-of-discharge remaining capacity ($aRC_{EOD}$) of said battery, and wherein said processor is configured to estimate said current full available charge capacity (DFC) according to the following equation:

$$DFC=FACC\times(aRC_N-aRC_{EOD})/(pFACC\times rSOC_{N-1}),$$

where DFC represents said current full available charge capacity, $aRC_N$ represents said current absolute remaining capacity, and $aRC_{EOD}$ represents said end-of-discharge remaining capacity, pFACC represents a predetermined full absolute charge capacity of said battery, and $rSOC_{N-1}$ represents a previously estimated available state of charge of said battery.

5. The battery management controller (202, 802) of claim 4, wherein said processor is configured to estimate said current available state of charge ($rSOC_N$) according to the following equation:

$$rSOC_N=[(DFC\times rSOC_{N-1})+Q(t)]/DFC,$$

where $rSOC_N$ represents said current available state of charge, and Q(t) presents said amount of charges flowing through said battery.

6. The battery management controller (202, 802) of any one of claims 1 to 5, wherein said memory is configured to store a state-of-charge lookup table (rSoC (OCV)) that comprises a plurality of data groups, and wherein each data group of said data groups comprises a voltage value (OCV) and a state of charge (rSoC) corresponding to said voltage value.

7. The battery management controller (202, 802) of claim 6, wherein said processor is configured to perform a plurality of operations comprising:

obtaining, from said analog-to-digital conversion circuitry (220), a first open-circuit voltage ($OCV_A$) of said battery in a first idle state;
searching said state-of-charge lookup table (rSoC (OCV)) for a first state of charge ($rSoC_A$) corresponding to said first open-circuit voltage ($OCV_A$);
obtaining, from said analog-to-digital conversion circuitry (220), a second open-circuit voltage ($OCV_A$) of said battery in a second idle state;
searching said state-of-charge lookup table (rSoC (OCV)) for a second state of charge ($rSoC_B$) corresponding to said second open-circuit voltage ($OCV_A$), wherein said battery is in a continuous charging state between said first idle state and said second idle state;
calculating a charge amount (($Q(t)_{CHG}$)) of said battery in said charging state; and
updating a current full absolute charge capacity (FACC) of said battery according to a ratio of said charge amount to a difference between said second sate of charge ($rSoC_B$) and said first state of charge ($rSoC_A$).

8. The battery management controller (202, 802) of claim 7, wherein said processor is configured to update said current full absolute charge capacity (FACC) of said battery according to a current charging aging factor (AFC) of said battery, and wherein said processor is configured to calculate said current charging aging factor according to the following equation:

$$AFC=Q(t)_{CHG}/(rSOC_B-rSOC_A),$$

where AFC represents said current charging aging factor, $Q(t)_{CHG}$ represents said charge amount, $rSOC_B$ represents said second state of charge, and $rSOC_A$ represents said first state of charge.

9. The battery management controller (202, 802) of claim 8, wherein said processor is configured to update said current full absolute charge capacity (FACC) according to the following equation:

$$FACC=FACC_0\times(AFC/AFC_0),$$

where FACC represents said current full absolute charge capacity, $FACC_0$ represents a previous full absolute charge capacity of said battery, and $AFC_0$ represents a previous charging aging factor of said battery.

**10.** The battery management controller (202, 802) of any one of claims 1 to 9, wherein said processor is configured to perform a plurality of operations comprising:

obtaining, from said analog-to-digital conversion circuitry (220), an open-circuit voltage (OCVc) of said battery in an idle state;

obtaining, from said analog-to-digital conversion circuitry (220), a discharge initial voltage ($V_D$) of said battery and a discharge current ($I_{DIS}$) of said battery in a load-on state, wherein said load-on state immediately follows said idle state; and

updating a current full absolute charge capacity (FACC) of said battery according to a ratio of a difference between said discharge initial voltage ($V_D$) and said open-circuit voltage (OCVc) to said discharge current ($I_{DIS}$).

**11.** The battery management controller (202, 802) of claim 10, wherein said processor is configured to update said current full absolute charge capacity (FACC) of said battery according to a current discharging aging factor (AFD) of said battery, and wherein said processor is configured to calculate said current discharging aging factor (AFD) according to the following equation:

$$AFD = (V_D - OCV_C)/I_{DIS},$$

where AFD presents said current discharging aging factor, $V_D$ presents said discharge initial voltage, OCVc presents said open-circuit voltage, and $I_{DIS}$ presents said discharge current.

**12.** The battery management controller (202, 802) of claim 11, wherein said processor is configured to update said current full absolute charge capacity (FACC) according to the following equation:

$$FACC = FACC_0 \times (AFD/AFD_0),$$

where FACC represents said current full absolute charge capacity $FACC_0$ represents a previous full absolute charge capacity of said battery, and $AFD_0$ represents a previous discharging aging factor of said battery.

**13.** The battery management controller (202, 802) of any one of claims 10 to 12. wherein said analog-to-digital conversion circuitry (202) comprises:

a first analog-to-digital convertor (238A, 238B), wherein said processor receives, from said first analog-to-digital convertor, a signal indicative of a battery current ($I_{BAT}$) of said battery thereby obtaining said amount of charges (Q(t)) flowing through said battery; and

a second analog-to-digital convertor (236), wherein said processor receives, from said second analog-to-digital convertor, a signal indicative of said discharge initial voltage ($V_D$) and a signal indicative of said discharge current ($I_{DIS}$) thereby calculating a current discharging aging factor (AFD) of said battery, wherein a speed of conversion of said second analog-to-digital convertor is higher than a speed of conversion of said first analog-to-digital convertor.

**14.** The battery management controller (202, 802) of any one of claims 1 to 13, further comprising a discharge time database ($\Delta t$ ($RI_{DIS}$, $T_{INITIAL}$)) stored in a memory, wherein said discharge time database ($\Delta t$ ($RI_{DIS}$, $T_{INITIAL}$)) comprises a plurality of sets of data, and each set of data of said plurality of sets of data comprises a discharge rate ($RI_{DIS}$), an initial temperature ($T_{INITIAL}$), and an available total discharge time ($\Delta t_{TOT\_R}$) corresponding to said discharge rate ($RI_{DIS}$) and said initial temperature ($T_{INITIAL}$), and wherein said processor is configured to estimate said end-of-discharge temperature ($T_{EOD}$) based on said discharge time database ($\Delta t$ ($RI_{DIS}$, $T_{INITIAL}$)).

**15.** The battery management controller (202, 802) of claim 14, wherein said processor is configured to estimate an assumed initial temperature ($T_{INITIAL}$) of said battery based on a current absolute state of charge ($aSoC_N$) of said battery and a current discharge rate ($RI_{DIS}$) of said battery, search said discharge time database ($\Delta t$ ($RI_{DIS}$, $T_{INITIAL}$)) for an assumed available total discharge time ($\Delta T_{TOT\_R}$) that corresponds to said current discharge rate ($RI_{DIS}$) and said assumed initial temperature ($T_{INITIAL}$), and estimate said end-of-discharge temperature ($T_{EOD}$) of said battery according to said assumed available total discharge time ($\Delta t_{TOT\_R}$).

**Patentansprüche**

1. Batterie-Management-Controller (202, 802), umfassend:

eine Analog-Digital-Umwandlungsschaltung (220), die eingerichtet ist für die Umwandlung von analogen Signalen (214, 216, 222), die die aktuelle Batteriespannung ($V_N$), einen aktuellen Batteriestrom ($I_N$) und eine aktuelle Batterietemperatur ($T_N$) einer Batterie anzeigen, in digitale Signale (234);
einen Speicher (230), der eingerichtet ist zum Speichern einer Restkapazität-Lookup-Tabelle (aRC(V, I, T)), die eine Mehrzahl von Gruppen von Daten enthält, jede Gruppe dieser Gruppen von Daten enthaltend eine Spannung (V), einen Strom (I), eine Temperatur (T) und einen Parameter (aRC, aSoC), der einer der Spannung (V), dem Strom (I) und der Temperatur (T) entsprechenden Restkapazität (aRC) zugeordnet ist;
einen Prozessor (228), der mit der Digital-Analog-Umwandlungsschaltung (220) und dem Speicher verbunden ist und eingerichtet ist für den Empfang eines einen Batteriestrom ($I_{Bat}$) anzeigenden Signals (232A, 232B) von der Analog-Digital-Umwandlungsschaltung (220), wobei die Menge der Ladungen (Q(t)), die durch die Batterie hindurchfließen, gezählt wird, eingerichtet ist zum Durchsuchen der Restkapazität-Lookup-Tabelle (aRC (V, I, T)) nach einem aktuellen Parameterwert ($aRC_N$, $aSoC_N$), der der aktuellen Batteriespannung ($V_N$), dem aktuellen Batteriestrom ($I_N$) und der aktuellen Batterietemperatur ($T_N$) gemäß den digitalen Signalen (234) entspricht, eingerichtet ist zum Durchsuchen der Restkapazität-Lookup-Tabelle (aRC (V, I, T) nach einem Entladungsende-Parameterwert ($aRC_{EOD}$), $ASoC_{EOD}$) entsprechend einer Entladungsende-Spannung ($V_{EOD}$), der den Eintritt in einen Entladungsende-Zustand zum Schutz der Batterie vor Überentladung, den aktuellen Batteriestrom ($I_N$) und eine Entladungsende-Temperatur ($T_{EOD}$) anzeigt, eingerichtet ist zum Schätzen einer aktuellen voll verfügbaren Ladekapazität (DFC) der Batterie gemäß einer Differenz zwischen dem aktuellen Parameterwert ($aRC_N$, $aSoC_N$) und dem Entladungsende-Parameterwert ($aRC_{EOD}$), $aSoC_{EOD}$) und eingerichtet ist zum Schätzen eines aktuell verfügbaren Ladezustands ($rSOC_N$) der Batterie gemäß der aktuellen voll verfügbaren Ladekapazität (DFC) und der Menge von Ladungen (Q(t)), die durch die Batterie hindurchfließen.

2. Batterie-Management-Controller (202, 802) nach Anspruch 1, wobei der Parameter (aRC, aSoC) einen Ladezustand (aSoC) umfasst, der aktuelle Parameterwert ($aRC_N$, $aSoC_N$) einen aktuellen absoluten Ladezustand ($aSoC_N$) der Batterie und der Entladungsende-Parameterwert ($aRC_{EOD}$, $aSoC_{EOD}$) einen Entladungsende(EOD)-Ladezustand ($aSoC_{EOD}$) der Batterie umfasst und wobei der Prozessor eingerichtet ist zum Schätzen der aktuell voll verfügbaren Ladekapazität (DFC) gemäß folgender Gleichung:

$$DFC = FACC \times (aSOC_N - aSOC_{EOD}) / rSOC_{N-1},$$

wobei DFC für die aktuelle voll verfügbare Ladekapazität, FACC für eine aktuelle volle absolute Ladekapazität der Batterie, $aSOC_N$ für den aktuellen absoluten Ladezustand und $aSOC_{EOD}$ für den Entladungsende-Ladezustand steht und $rSOC_{N-1}$ für ein zuvor geschätzten verfügbaren Ladezustand der Batterie steht.

3. Batterie-Management-Controller (202, 802) nach Anspruch 2, wobei der Prozessor eingerichtet ist zum Schätzen des aktuellen verfügbaren Ladezustands ($rSOC_N$) gemäß folgender Gleichung:

$$rSOC_N = [(DFC \times rSOC_{N-1}) + Q(t)] / DFC,$$

wobei $rSOC_N$ für den aktuellen verfügbaren Ladezustand und Q(t) für die Menge von Ladungen, die durch die Batterie hindurchfließen, steht.

4. Batterie-Management-Controller (202, 802) nach Anspruch 1, wobei der Parameter (aRC, aSoC) eine Restkapazität (aRC) umfasst, der aktuelle Parameterwert ($aRC_N$, $aSoC_N$) eine aktuelle absolute Restkapazität ($aRC_N$) der Batterie umfasst und der Entladungsende-Parameterwert ($aRC_{EOD}$, $aSoC_{EOD}$) eine Entladungsende-Restkapazität ($aRC_{EOD}$) der Batterie umfasst und wobei der Prozessor eingerichtet ist zum Schätzen der aktuellen vollen verfügbaren Ladekapazität (DFC) gemäß folgender Gleichung:

$$DFC = FACC \times (aRC_N - aRC_{EOD}) / (pFACC \times rSOC_{N-1}),$$

wobei DFC für die aktuelle volle verfügbare Ladekapazität, $aRC_N$ für die aktuelle absolute Restkapazität und $aRC_{EOD}$

für die Entladungsende-Restkapazität, pFACC für eine vorgegebene volle absolute Ladekapazität der Batterie und $rSOC_{N-1}$ für eine zuvor geschätzten verfügbaren Ladezustand der Batterie steht.

5. Batterie-Management-Controller (202, 802) nach Anspruch 4, wobei der Prozessor eingerichtet ist zum Schätzen des aktuellen verfügbaren Ladezustands ($rSOC_N$) gemäß folgender Gleichung:

$$rSOC_N = [(DFC \times rSOC_{N-1}) + Q(t)]/DFC,$$

wobei $rSOC_N$ für den aktuellen verfügbaren Ladezustand und $Q(t)$ für die Menge von Ladungen, die durch die Batterie hindurchfließen, steht.

6. Batterie-Management-Controller (202, 802) nach einem der Ansprüche 1 bis 5, wobei der Speicher eingerichtet ist zum Speichern einer Ladezustand-Lookup-Tabelle ($rSoC$ ($OCV$)), die eine Mehrzahl von Datengruppen enthält, wobei jede Datengruppe der Datengruppen einen Spannungswert ($OCV$) und einen Ladezustand ($rSoC$) entsprechend dem Spannungswert enthält.

7. Batterie-Management-Controller (202, 802) nach Anspruch 6, wobei der Prozessor eingerichtet ist zum Durchführen einer Mehrzahl von Vorgängen, umfassend:

das Beziehen einer ersten Leerlaufspannung ($OCV_A$) der Batterie in einem ersten Leerlaufzustand von der Analog-Digital-Umwandlungsschaltung;
das Durchsuchen der Ladezustand-Lookup-Tabelle ($rSoC$ ($OCV$)) nach einem ersten Ladezustand ($rSoC_A$) entsprechend der ersten Leerlaufspannung ($OCV_A$);
das Beziehen einer zweiten Leerlaufspannung ($OCV_A$) der Batterie in einem zweiten Leerlaufzustand von der Analog-Digital-Umwandlungsschaltung (220);
das Durchsuchen der Ladezustand-Lookup-Tabelle ($rSoC$ ($OCV$)) nach einem zweiten Ladezustand ($rSoC_B$) entsprechend der zweiten Leerlaufspannung ($OCV_A$), wobei sich die Batterie zwischen dem ersten Leerlaufzustand und dem zweiten Leerlaufzustand in einem kontinuierlichen Ladezustand befindet;
das Berechnen einer Ladungsmenge (($Q(t)_{CHG}$)) der Batterie im Ladezustand; und
das Aktualisieren einer aktuellen vollen absoluten Ladekapazität (FACC) der Batterie gemäß einem Verhältnis der Ladungsmenge zu einer Differenz zwischen dem zweiten Ladezustand ($rSoC_B$) und dem ersten Ladezustand ($rSoC_A$).

8. Batterie-Management-Controller (202, 802) nach Anspruch 7, wobei der Prozessor eingerichtet ist zum Aktualisieren der aktuellen vollen absoluten Ladekapazität (FACC) der Batterie gemäß einem aktuellen Ladealterungsfaktor (AFC) der Batterie und wobei der Prozessor eingerichtet ist zum Berechnen des aktuellen Ladealterungsfaktors gemäß folgender Gleichung:

$$AFC = Q(t)_{CHG}/(rSIOC_B - rSOC_A),$$

wobei AFC für den aktuellen Ladealterungsfaktor, $Q(t)CHG$ für die Ladungsmenge, $rSOC_B$ für den zweiten Ladezustand und $rSOC_A$ für den ersten Ladezustand steht.

9. Batterie-Management-Controller (202, 802) nach Anspruch 8, wobei der Prozessor eingerichtet ist zum Aktualisieren der aktuellen vollen absoluten Ladekapazität (FACC) gemäß folgender Gleichung:

$$FACC = FACC_0 \times (AFC/AFC_0),$$

wobei FACC für die aktuelle volle absolute Ladekapazität, $FACC_0$ für eine vorherige volle absolute Ladekapazität der Batterie und $AFC_0$ für einen vorherigen Ladealterungsfaktor der Batterie steht.

10. Batterie-Management-Controller (202, 802) nach einem der Ansprüche 1 bis 9, wobei der Prozessor eingerichtet ist zum Durchführen einer Mehrzahl von Vorgängen, umfassend:

das Beziehen einer Leerlaufspannung (OCVc) der Batterie in einem Leerlaufzustand von der Analog-Digital-Umwandlungsschaltung (220);

das Beziehen einer Entladeanfangsspannung ($V_D$) der Batterie und eines Entladestroms ($I_{DIS}$) der Batterie in einem Zustand unter Last von der Analog-Digital-Umwandlungsschaltung (220), wobei der Zustand unter Last unmittelbar auf den Leerlaufzustand folgt; und

das Aktualisieren einer aktuellen vollen absoluten Ladekapazität (FACC) der Batterie gemäß einem Verhältnis der Differenz zwischen der Entladeanfangsspannung ($V_D$) und der Leerlaufspannung (OCVc) zu dem Entladestrom ($I_{DIS}$).

11. Batterie-Management-Controller (202, 802) nach Anspruch 10, wobei der Prozessor eingerichtet ist zum Aktualisieren der aktuellen vollen absoluten Ladekapazität (FACC) der Batterie gemäß einem aktuellen Entladealterungsfaktor (AFD) der Batterie und wobei der Prozessor eingerichtet ist zum Berechnen des aktuellen Entladealterungsfaktors (AFD) gemäß folgender Gleichung:

$$\mathrm{AFD} = (V_D - OCV_C) / I_{DIS},$$

wobei AFD für den aktuellen Entladealterungsfaktor, $V_D$ für die Entladeanfangsspannung, OCVc für die Leerlaufspannung und $I_{DIS}$ für den Entladestrom steht.

12. Batterie-Management-Controller (202, 802) nach Anspruch 11, wobei der Prozessor eingerichtet ist zum Aktualisieren der aktuellen vollen absoluten Ladekapazität (FACC) gemäß folgender Gleichung:

$$\mathrm{FACC} = \mathrm{FACC}_0 \times (AFD / AFD_0),$$

wobei FACC für die aktuelle volle absolute Ladekapazität, $FACC_0$ für eine vorherige volle absolute Ladekapazität der Batterie $FACC_0$ und $AFD_0$ für einen vorherigen Entladealterungsfaktor der Batterie steht.

13. Batterie-Management-Controller (202, 802) nach einem der Ansprüche 10 bis 12, wobei die Analog-Digital-Umwandlungsschaltung (202) umfasst:

einen ersten Analog-Digital-Wandler (238A, 238B, wobei der Prozessor von dem ersten Analog-Digital-Wandler ein Signal empfängt, das einen Batteriestrom ($I_{BAT}$) der Batterie anzeigt, und dadurch die Menge von Ladungen (Q(t)) bezieht, die durch die Batterie hindurchfließen; und

einen zweiten Analog-Digital-Wandler (236), wobei der Prozessor von dem zweiten Analog-Digital-Wandler ein Signal empfängt, das die Entladeanfangsspannung ($V_D$) anzeigt, und ein Signal, das den Entladestrom ($I_{DIS}$) anzeigt, und dadurch einen aktuellen Entladealterungsfaktor (AFD) der Batterie berechnet, wobei eine Umwandlungsgeschwindigkeit des zweiten Analog-Digital-Wandlers höher ist als eine Umwandlungsgeschwindigkeit des ersten Analog-Digital-Wandlers.

14. Batterie-Management-Controller (202, 802) nach einem der Ansprüche 1 bis 13, ferner umfassend eine in einem Speicher gespeicherte Entladezeit-Datenbank ($\Delta t$ ($RI_{DIS}$, $T_{INITIAL}$)) umfasst, wobei die Entladezeit-Datenbank ($\Delta t$ ($RI_{DIS}$, $T_{INITIAL}$)) eine Mehrzahl von Datensätzen enthält und jeder Datensatz der Mehrzahl von Datensätzen eine Entladerate ($RI_{DIS}$), eine Anfangstemperatur ($T_{INITIAL}$) und eine verfügbare Gesamtentladezeit ($\Delta t_{TOT\_R}$) entsprechend der Entladerate ($RI_{DIS}$) und der Anfangstemperatur ($T_{INITIAL}$) enthält und wobei der Prozessor eingerichtet ist zum Schätzen der Entladeende-Temperatur ($T_{EOD}$) auf der Grundlage der Entladezeit-Datenbank ($\Delta t$ ($RI_{DIS}$, $T_{INITIAL}$)).

15. Batterie-Management-Controller (202, 802) nach Anspruch 14, wobei der Prozessor eingerichtet ist zum Schätzen einer angenommenen Anfangstemperatur ($T_{INITIAL}$) der Batterie basierend auf einem aktuellen absoluten Ladezustand ($aSoC_N$) der Batterie und einer aktuellen Entladerate ($RI_{DIS}$) der Batterie, zum Durchsuchen der Entladezeit-Datenbank (($RI_{DIS}$, $T_{INITIAL}$)) nach einer angenommenen verfügbaren Gesamtentladezeit ($\Delta t_{TOT\_R}$), die der aktuellen Entladerate ($RI_{DIS}$) und der angenommenen Anfangstemperatur ($T_{INITIAL}$) entspricht, und zum Schätzen der Entladeende-Temperatur ($T_{EOD}$) der Batterie gemäß der angenommenen verfügbaren Gesamtentladezeit ($\Delta t_{TOT\_R}$).

**Revendications**

1. Contrôleur de gestion de batterie (202, 802), comprenant:

   un circuit de conversion analogique-numérique (220) adapté pour convertir des signaux analogiques (214, 216, 222) indiquant la tension de batterie courante ($V_N$), un courant de batterie courant ($I_N$) et une température de batterie courante ($T_N$) d'une batterie en signaux numériques (234);
   une mémoire (230) adaptée pour stocker une table de consultation de capacité résiduelle (aRC (V, I, T)) contenant une pluralité de groupes de données, chaque groupe desdits groupes de données comprenant une tension (V), un courant (I), une température (T) et un paramètre (aRC, aSoC) associé à une capacité résiduelle (aRC) correspondant à ladite tension (V), audit courant (I) et à ladite température (T);
   un processeur (228) connecté au circuit de conversion numérique-analogique (220) et à la mémoire, et agencé pour recevoir un signal (232A, 232B) indiquant un courant de batterie ($I_{Bat}$) provenant du circuit de conversion analogique-numérique (220), en comptant la quantité de charges (Q(t)) passant à travers la batterie, agencé pour rechercher dans la table de consultation de capacité résiduelle (aRC (V, I, T)) une valeur de paramètre courante ($aRC_N$, $aSoC_N$) correspondant à la tension de batterie courante ($V_N$), au courant de batterie courant ($I_N$) et à la température de batterie courante ($T_N$) selon les signaux numériques (234), agencé pour rechercher dans la table de consultation de capacité résiduelle (aRC (V, I ,T) pour une valeur de paramètre de fin de décharge ($aRC_{EOD}$), $ASoC_{EOD}$) correspondant à une tension en fin de décharge ($V_{EOD}$) indiquant l'entrée dans un état de fin de décharge pour protéger la batterie d'une décharge excessive, au courant de batterie courant ($I_N$) et à une température en fin de décharge ($T_{EOD}$), agencé pour estimer une capacité de charge courante entièrement disponible (DFC) de la batterie selon une différence entre la valeur de paramètre courante ($aRC_N$, $aSoC_N$) et la valeur du paramètre de fin de décharge ($aRC_{EOD}$), $ASoC_{EOD}$) et agencé pour estimer un état de charge courant disponible ($rSOC_N$) de la batterie en fonction de la capacité de charge courante entièrement disponible (DFC) et de la quantité de charges (Q(t)) qui s'écoulent à travers la batterie.

2. Contrôleur de gestion de batterie (202, 802) selon la revendication 1, dans lequel le paramètre (aRC, aSoC) comprend un état de charge (aSoC), la valeur du paramètre courante ($aRC_N$, $aSoC_N$) comprend un état de charge absolu courant ($aSoC_N$) de la batterie et la valeur du paramètre de fin de décharge ($aRC_{EOD}$, $aSoC_{EOD}$) comprend un état de charge ($aSOC_{EOD}$) en fin de décharge (EOD) de ladite batterie, et dans lequel le processeur est agencé pour estimer la capacité de charge entièrement disponible courante (DFC) selon l'équation suivante:

$$DFC = FACC \times (aSOC_N - aSOC_{EOD}) / rSOC_{N-1},$$

   où DFC représente la capacité de charge totale disponible courante, FACC représente une capacité de charge absolue totale courante de la batterie, $aSOC_N$ représente l'état de charge absolu courant et $aSOC_{EOD}$ représente l'état de charge en fin de décharge, et $rSOC_{N-1}$ représente un état de charge disponible de la batterie estimé précédemment.

3. Contrôleur de gestion de batterie (202, 802) selon la revendication 2, dans lequel le processeur est agencé pour estimer l'état de charge disponible courant ($rSOC_N$) selon l'équation suivante:

$$rSOC_N = [(DFC \times rSOC_{N-1}) + Q(t)] / DFC,$$

   où $rSOC_N$ représente l'état de charge disponible courant et Q(t) représente la quantité de charges qui traversent la batterie.

4. Contrôleur de gestion de batterie (202, 802) selon la revendication 1, dans lequel le paramètre (aRC, aSoC) comprend une capacité résiduelle (aRC), la valeur du paramètre courante ($aRC_N$, $aSoC_N$) comprend une capacité résiduelle absolue courante ($aRC_N$) de la batterie et la valeur du paramètre en fin de décharge ($aRC_{EOD}$, $ASoC_{EOD}$) comprend une capacité résiduelle en fin de décharge ($aRC_{EOD}$) de la batterie et dans lequel le processeur est agencé pour estimer la capacité de charge totale disponible courante (DFC) selon l'équation suivante:

$$DFC = FACC \times (aRC_N - aRC_{EOD}) / (pFACC \times rSOC_{N-1}),$$

où DFC représente la capacité de charge totale courante disponible, $aRC_N$ représente la capacité résiduelle absolue courante et $aRC_{EOD}$ représente la capacité résiduelle en fin de décharge, pFACC représente une capacité de charge absolue totale prédéterminée de la batterie et $rSOC_{N-1}$ représente un état de charge disponible de la batterie estimé précédemment.

5. Contrôleur de gestion de batterie (202, 802) selon la revendication 4, dans lequel le processeur est agencé pour estimer l'état de charge disponible courant ($rSOC_N$) selon l'équation suivante:

$$rSOC_N = [(DFC \times rSOC_{N-1}) + Q(t)] / DFC,$$

où $rSOC_N$ représente l'état de charge disponible courant et Q(t) la quantité de charges qui traversent la batterie.

6. Contrôleur de gestion de batterie (202, 802) selon l'une quelconque des revendications 1 à 5, dans lequel la mémoire est agencée pour stocker une table de consultation d'état de charge (rSoC (OCV)) comprenant une pluralité de groupes de données, chaque groupe de données des groupes de données comprenant une valeur de tension (OCV) et un état de charge (rSoC) correspondant à la valeur de tension.

7. Contrôleur de gestion de batterie (202, 802) selon la revendication 6, dans lequel le processeur est agencé pour effectuer une pluralité d'opérations comprenant:

l'obtention d'une première tension de circuit ouvert ($OCV_A$) de la batterie dans un premier état de circuit ouvert à partir du circuit de conversion analogique-numérique;
la recherche dans table de consultation d'état de charge (rSoC (OCV)) d'un premier état de charge ($rSoC_A$) correspondant à la première tension de circuit ouvert ($OCV_A$);
l'obtention d'une seconde tension de circuit ouvert ($OCV_A$) de la batterie dans un second état de circuit ouvert à partir du circuit de conversion analogique-numérique (220);
la recherche dans la table de consultation d'état de charge (rSoC (OCV)) d'un deuxième état de charge ($rSoC_B$) correspondant à la deuxième tension de circuit ouvert ($OCV_A$), la batterie étant dans un état de charge continu entre le premier état de circuit ouvert et le deuxième état de circuit ouvert;
le calcul d'une quantité de charge (($Q(t)_{CHG}$)) de la batterie dans l'état de charge; et
la mise à jour d'une capacité de charge absolue totale courante (FACC) de la batterie selon un rapport de la quantité de charge sur une différence entre le deuxième état de charge ($rSoC_B$) et le premier état de charge ($rSoC_A$).

8. Contrôleur de gestion de batterie (202, 802) selon la revendication 7, dans lequel le processeur est agencé pour mettre à jour la capacité de charge absolue totale courante (FACC) de la batterie selon un facteur de vieillissement de charge courant (AFC) de la batterie et dans lequel le processeur est agencé pour calculer le facteur de vieillissement de charge courant selon l'équation suivante:

$$AFC = Q(t)_{CHG} / (rSIOC_B - rSOC_A),$$

où AFC représente le facteur de vieillissement de charge courant, $Q(t)_{CHG}$ représente la quantité de charge, $rSOC_B$ représente le deuxième état de charge et $rSOC_A$ représente le premier état de charge.

9. Contrôleur de gestion de batterie (202, 802) selon la revendication 8, dans lequel le processeur est agencé pour mettre à jour la capacité de charge absolue totale courante (FACC) selon l'équation suivante:

$$FACC = FACC_0 \times (AFC / AFC_0),$$

où FACC représente la capacité de charge absolue totale courante, $FACC_0$ représente une capacité de charge absolue totale précédente de la batterie et $AFC_0$ représente un facteur de vieillissement de charge précédent de la batterie.

10. Contrôleur de gestion de batterie (202, 802) selon l'une quelconque des revendications 1 à 9, dans lequel le processeur est agencé pour effectuer une pluralité d'opérations comprenant:

l'obtention d'une tension de circuit ouvert ($OCV_C$) de la batterie dans un état de circuit ouvert à partir du circuit de conversion analogique-numérique (220);

l'obtention d'une tension initiale de décharge ($V_D$) de la batterie et d'un courant de décharge ($I_{DIS}$) de la batterie dans un état de charge à partir du circuit de conversion analogique-numérique (220), l'état de charge suivant immédiatement l'état de circuit ouvert; et

la mise à jour d'une capacité de charge absolue totale courante (FACC) de la batterie selon un rapport de la différence entre la tension de début de décharge ($V_D$) et la tension de circuit ouvert (OCVc) sur le courant de décharge ($I_{DIS}$).

**11.** Contrôleur de gestion de batterie (202, 802) selon la revendication 10, dans lequel le processeur est agencé pour mettre à jour la capacité de charge absolue totale courante (FACC) de la batterie selon un facteur de vieillissement de décharge courant (AFD) de la batterie, et dans lequel le processeur est agencé pour calculer le facteur de vieillissement de décharge courant (AFD) selon l'équation suivante:

$$AFD = (V_D - OCV_C) / I_{DIS},$$

où AFD représente le facteur de vieillissement de décharge courant, $V_D$ représente la tension de début de décharge, OCVc représente la tension de circuit ouvert et $I_{DIS}$ représente le courant de décharge.

**12.** Contrôleur de gestion de batterie (202, 802) selon la revendication 11, dans lequel le processeur est agencé pour mettre à jour la capacité de charge absolue totale courante (FACC) selon l'équation suivante:

$$FACC = FACC_0 x (AFD / AFD_0),$$

où FACC représente la capacité de charge absolue totale courante, $FACC_0$ représente une capacité de charge absolue totale précédente de la batterie $FACC_0$ et $AFD_0$ représente un facteur de vieillissement de décharge précédent de la batterie.

**13.** Contrôleur de gestion de batterie (202, 802) selon l'une quelconque des revendications 10 à 12, dans lequel le circuit de conversion analogique-numérique (202) comprend:

un premier convertisseur analogique-numérique (238A, 238B), le processeur recevant du premier convertisseur analogique-numérique un signal indicatif d'un courant de batterie ($I_{BAT}$) de la batterie, et obtenant ainsi la quantité de charges (Q(t)) circulant à travers la batterie; et

un deuxième convertisseur analogique-numérique (236), le processeur recevant du deuxième convertisseur analogique-numérique un signal indiquant la tension de début de décharge ($V_D$) et un signal indiquant le courant de décharge ($I_{DIS}$), et calculant ainsi un facteur de vieillissement de décharge courant (AFD) de la batterie, dans lequel une vitesse de conversion du deuxième convertisseur analogique-numérique est supérieure à une vitesse de conversion du premier convertisseur analogique-numérique.

**14.** Contrôleur de gestion de batterie (202, 802) selon l'une quelconque des revendications 1 à 13, comprenant en outre une base de données de temps de décharge ($\Delta t$ ($RI_{DIS}$, $T_{INITIAL}$)) stockée dans une mémoire, dans lequel la base de données de temps de décharge ($\Delta t$ ($RI_{DIS}$, $T_{INITIAL}$)) contient une pluralité d'enregistrements, chaque enregistrement de la pluralité d'enregistrements comprenant un taux de décharge ($RI_{DIS}$), une température initiale ($T_{INITIAL}$) et un temps de décharge total disponible ($\Delta t_{TOT\_R}$) correspondant au taux de décharge ($RI_{DIS}$) et à la température initiale ($T_{INITIAL}$), et dans lequel le processeur est agencé pour estimer la température en fin de décharge ($T_{EOD}$) sur la base de la base de données de temps de décharge ($\Delta t$ ($RI_{DIS}$, $T_{INITIAL}$)).

**15.** Contrôleur de gestion de batterie (202, 802) selon la revendication 14, dans lequel le processeur est agencé pour estimer une température initiale supposée ($T_{INITIAL}$) de la batterie sur la base d'un état de charge absolu courant ($aSoC_N$) de la batterie et d'un taux de décharge courant ($RI_{DIS}$) de la batterie, pour rechercher dans la base de données de temps de décharge ($\Delta t$ ($RI_{DIS}$, $T_{INITIAL}$)) pour un temps de décharge total disponible présumé ($\Delta t_{TOT\_R}$) correspondant au taux de décharge courant ($RI_{DIS}$) et à la température initiale présumée ($T_{INITIAL}$), et pour estimer la température en fin de décharge ($T_{EOD}$) de la batterie en fonction du temps de décharge total disponible présumé ($\Delta t_{TOT\_R}$).

FIG. 1A

FIG. 1B

FIG. 2A

FIG. 2B

EP 3 889 626 B1

FIG. 3

EP 3 889 626 B1

FIG. 4

500

502

No — Idle state?

Yes

504

Obtain OCV and rSOC, and store them in a register

506

Yes — Charge-on state? → Calculate Q(t) — 512

No

No — Load-on state?

Yes

514

No — Idle state?

Yes — 516

508

Detect $V_D$ and $I_{DIS}$

Obtain $Q(t)_{CHG}$; Obtain OCV' and rSOC'; and store them in the register — 516

510

Calculate AFD and store it in the register

Calculate AFC and store it in the register — 518

522

Go to step 502

520

No — $AFD_0$ is found? ← No — $AFC_0$ is found?

Yes — Yes

Update FACC according to equation (8) and store it in the register — 524

$AFD_0$ is found? — No → Update FACC according to equation (6) and store it in the register — 526

Yes

Update FACC according to equation (9) and store it in the register — 528

FIG. 5

FIG. 6A

FIG. 6B

FIG. 6C

FIG. 6D

FIG. 7

FIG. 8

900A

$$\boxed{\text{OBTAINING A RECENT } aSoC_{N-1} \text{ AND A CURRENT } RI_{DIS}} \quad \underset{\text{—902}}{}$$

$$\boxed{\text{ESTIMATING AN ASSUMED } \Delta t_{PAST} \text{ ACCORDING TO } aSoC_N \text{ AND } RI_{DIS}} \quad \underset{\text{—904}}{}$$

$$\boxed{\text{ESTIMATING AN ASSUMED } E_{PAST} \text{ ACCORDING TO } \Delta t_{PAST}, I_{DIS} \text{ AND } V_{NOM}} \quad \underset{\text{—906}}{}$$

$$\boxed{\text{OBTAINING } K_N \text{ ACCORDING TO } I_{DIS}} \quad \underset{\text{—908}}{}$$

$$\boxed{\text{ESTIMATING AN ASSUMED } \Delta T_{CHANGE} \text{ ACCORDING TO } K_N \text{ AND } E_{PAST}} \quad \underset{\text{—910}}{}$$

$$\boxed{\text{ESTIMATING AN ASSUMED } T_{INITIAL} \text{ ACCORDING TO } T_N \text{ AND } \Delta T_{CHANGE}} \quad \underset{\text{—912}}{}$$

$$\boxed{\text{SEARCHING THE } \Delta t \text{ DATABASE FOR } \Delta t_{TOT\_R} \text{ BASED ON } RI_{DIS} \text{ AND } T_{INITIAL}} \quad \underset{\text{—914}}{}$$

$$\boxed{\text{ESTIMATING } E_{DIS} \text{ ACCORDING TO } \Delta t_{TOT\_R}, I_{DIS} \text{ AND } V_{NOM}} \quad \underset{\text{—916}}{}$$

$$\boxed{\text{ESTIMATING } \Delta T_{EOD} \text{ ACCORDING TO } K_N \text{ AND } E_{DIS}} \quad \underset{\text{—918}}{}$$

$$\boxed{\text{ESTIMATING } T_{EOD} \text{ ACCORDING TO } \Delta T_{EOD} \text{ AND } T_{INITIAL}} \quad \underset{\text{—920}}{}$$

FIG. 9A

900B

OBTAINING A CURRENT $aSoC_{N-1}$ AND A CURRENT $RI_{DIS}$ — 902

ESTIMATING AN ASSUMED $\Delta t_{PAST}$ ACCORDING TO $aSoC_N$ AND $RI_{DIS}$ — 904

ESTIMATING AN ASSUMED $E_{PAST}$ ACCORDING TO $\Delta t_{PAST}$, $I_{DIS}$ AND $V_{NOM}$ — 906

OBTAINING $K_N$ ACCORDING TO $I_{DIS}$ — 908

ESTIMATING AN ASSUMED $\Delta T_{CHANGE}$ ACCORDING TO $K_N$ AND $E_{PAST}$ — 910

ESTIMATING AN ASSUMED $T_{INITIAL}$ ACCORDING TO $T_N$ AND $\Delta T_{CHANGE}$ — 912

SEARCHING THE $\Delta t$ DATABASE FOR $\Delta t_{TOT\_R}$ BASED ON $RI_{DIS}$ AND $T_{INITIAL}$ — 914

ESTIMATING A REMAINED $\Delta t_{REM}$ ACCORDING TO $\Delta t_{TOT\_R}$ AND $\Delta t_{PAST}$ — 922

ESTIMATING A REMAINED $E_{DIS\_REM}$ ACCORDING TO $\Delta t_{REM}$, $I_{DIS}$ AND $V_{NOM}$ — 924

ESTIMATING A REMAINED $\Delta T_{EOD\_REM}$ ACCORDING TO $K_N$ AND $E_{DIS\_REM}$ — 926

ESTIMATING $T_{EOD}$ ACCORDING TO $\Delta T_{EOD\_REM}$ AND $T_N$ — 928

FIG. 9B

FIG. 10

**EP 3 889 626 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010124840
- US 20080233469 A1
- EP 3182552 A1
- US 20150231986 A1

**Non-patent literature cited in the description**

- **A, FARMANN et al.** Critical review of on-board capacity estimation techniques for lithium-ion batteries in electric and hybrid electric vehicles. *Journal of Power Sources,* vol. 281 (215), 114-130